(19) Europäisches Patentamt
European Patent Office
Office européen des brevets

(11) **EP 2 100 190 B1**

(12) **EUROPÄISCHE PATENTSCHRIFT**

(45) Veröffentlichungstag und Bekanntmachung des Hinweises auf die Patenterteilung:
**04.04.2012   Patentblatt 2012/14**

(21) Anmeldenummer: **07846805.5**

(22) Anmeldetag: **24.11.2007**

(51) Int Cl.:
***G02B 27/09*** *(2006.01)*      ***G03F 7/20*** *(2006.01)*

(86) Internationale Anmeldenummer:
**PCT/EP2007/010234**

(87) Internationale Veröffentlichungsnummer:
**WO 2008/071305 (19.06.2008 Gazette 2008/25)**

(54) **PROJEKTIONSBELICHTUNGSANLAGE FÜR DIE MIKROLITHOGRAPHIE**

PROJECTION EXPOSURE APPARATUS FOR MICROLITHOGRAPHY

DISPOSITIF D'EXPOSITION PAR PROJECTION POUR LA MICROLITHOGRAPHIE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **14.12.2006   DE 102006059024**
**14.12.2006   US 874770 P**

(43) Veröffentlichungstag der Anmeldung:
**16.09.2009   Patentblatt 2009/38**

(73) Patentinhaber: **Carl Zeiss SMT GmbH**
**73447 Oberkochen (DE)**

(72) Erfinder:
• **ENDRES, Martin**
**89551 Königsbronn (DE)**
• **OSSMANN, Jens**
**73430 Aalen (DE)**
• **STÜTZLE, Ralf**
**73430 Aalen (DE)**

(74) Vertreter: **Carl Zeiss AG - Patentabteilung**
**Carl-Zeiss-Strasse 22**
**73447 Oberkochen (DE)**

(56) Entgegenhaltungen:
**EP-A- 1 349 009      WO-A-2006/066638**
**WO-A-2006/136353      JP-A- 9 148 234**

**Beschreibung**

Die Erfindung betrifft eine Projektionsbelichtungsanlage für die Mikrolithographie. Ferner betrifft die Erfindung eine Beleuchtungsoptik für eine derartige Projektionsbelichtungsanlage, ein Verfahren zum Betrieb einer derartigen Projektionsbelichtungsanlage, ein Verfahren zur Herstellung eines mikrostrukturierten Bauteils sowie ein durch das Verfahren hergestelltes mikrostrukturiertes Bauteil.

Projektionsbelichtungsanlagen für die Mikrolithographie sind unter anderem bekannt aus der EP 1 349 009 A2, die eine Projektionsbelichtungsanlage gemäß der Präambel des Anspruchs 1 Offenbart, und den im dortigen Recherchenbericht genannten Druckschriften. Weitere Projektionsbelichtungsanlagen für die Mikrolithographie sind bekannt aus der US 6,859,328 B2, der US 6,658,084 B2, der WO 2005/015314 A2, der US 6,452,661 B1, der US 2006/0012767 A1, der EP 1 067 437 B1 und der US 2003/0031017 A1.

Gerade für anspruchsvolle Projektionsbelichtungsaufgaben ausgelegte derartige Projektionsbelichtungsanlagen haben, was deren Beleuchtungsparameter, insbesondere was die Beleuchtungsparameter Verzeichnung, Telezentrie und Elliptizität angeht, noch Verbesserungsbedarf.

Es ist daher eine Aufgabe der vorliegenden Erfindung, eine Projektionsbelichtungsanlage der eingangs genannten Art derart weiterzubilden, dass deren Beleuchtungsparameter, insbesondere die Beleuchtungsparameter Verzeichnung, Telezentrie und Elliptizität verbessert sind.

Diese Aufgabe ist erfindungsgemäß gelöst durch eine Projektionsbelichtungsanlage für die Mikrolithographie gemäß Anspruch 1.

Erfindungsgemäß wurde erkannt, dass über den Blendenrand einer Korrekturblende Einfluss auf Beleuchtungsparameter der Beleuchtungsoptik, insbesondere auf eine Verzeichnungswirkung der abbildenden optischen Gruppe vor der Objektebene, genommen werden kann. Dies kann dazu genutzt werden, diese Parameter so zu optimieren, dass die Abweichung dieser Parameter von Vorgabewerten minimiert ist. Die Form des Blendenrandes kann also insbesondere zur Vorkompensation eines durch die abbildende optische Baugruppe vor der Objektebene hervorgerufenen Verzeichnungsfehlers vorgegeben werden. Insbesondere ist eine Anpassung einer Abschattung eines Pupillenfacettenspiegels der Beleuchtungsoptik an verschiedene Geometrien der abbildenden optischen Baugruppe vor der Objektebene sowie an verschiedene Beleuchtungssettings möglich. Beispielsweise kann eine elliptische Randkontur des Blendenrandes der Korrekturblende dazu führen, dass die Kombination eines entsprechend elliptisch vorgeformten Strahlenbündels mit der verzeichnenden Wirkung der nachfolgenden abbildenden optischen Baugruppe vor der Objektebene zu einer gewünscht rotationssymmetrischen Beleuchtungswinkelverteilung der Beleuchtung der Feldpunkte des Objektfeldes führt.

Die Korrekturblende ist in oder benachbart zu einer Pupillenebene der Projektionsoptik oder in oder benachbart zu ein einer Ebene, die zu einer Pupillenebene der Projektionsoptik konjugiert angeordnet ist, angeordnet.

Ein Pupillenfacettenspiegel mit einer Mehrzahl von mit Beleuchtungslicht beaufschlagbaren Einzelfacetten , der in einer Ebene der Beleuchtungsoptik angeordnet ist, die mit einer Pupillenebene der Projektionsoptik zusammenfällt oder zu dieser optisch konjugiert ist, ermöglicht eine definierte Vorgabe einer Beleuchtungsmittelverteilung über das Objektfeld.

Eine Ausgestaltung derart, dass die Korrekturblende so angeordnet ist, dass zumindest einige Quellbilder in der Eintrittspupille der Projektionsoptik, die den Einzelfacetten des Pupillenfacettenspiegels zugeordnet sind, von ein und demselben Blendenrand teilweise abgeschattet werden, erlaubt eine feine Vorgabe der Beleuchtungsparameter der Projektionsbelichtungsanlage, ohne dass hierbei der Blendenrand auf die Form von Einzelfacetten angepasst sein muss. Ein derartiger Blendenrand lässt sich mit vergleichsweise geringem Aufwand herstellen.

Die verzeichnungskorrigierenden Eigenschaften der Korrekturblende kommen bei einer Ausgestaltung der Beleuchtungsoptik mit einem Feldfacettenspiegel mit Feldfacetten, die mit der optischen Baugruppe in das Objektfeld abgebildet werden, besonders gut zum Tragen.

Bogenförmige Feldfacetten werden in der Regel im Zusammenhang mit einem bogenförmigen auszuleuchtenden Objektfeld eingesetzt. Das Bogenfeld wird oftmals von einem Spiegel für streifenden Einfall (grazing incidence Spiegel) erzeugt, der Bestandteil der abbildenden optischen Baugruppe vor der Objektebene ist. Die Korrekturblende sorgt insbesondere dafür, dass eine durch diesen Spiegel für streifenden Einfall hervorgerufene verzeichnende Wirkung kompensiert wird.

Bei einer Projektionsbelichtungsanlage, bei der die Korrekturblende dem Pupillenfacettenspiegel benachbart angeordnet ist, kann die Korrekturblende gemeinsam mit dem Pupillenfacettenspiegel als Baueinheit gestaltet sein. Zu dieser Baueinheit kann insbesondere ein mit dem Pupillenfacettenspiegel verbundener Korrekturblenden-Wechselhalter gehören, der die Verwendung verschiedener Korrekturblenden mit ein und demselben Pupillenfacettenspiegel ermöglicht. Der Wechselhalter kann alternativ auch ein vom Pupillenfacettenspiegel unabhängiges Bauteil sein.

Die unkorrigierte Umfangskontur einer Blende kann durch Strahlen definiert werden, die vom Blendenrand der unkorrigierten Blende ausgehen und durch die Mitte eines Feldes, also z. B. des Objekt- oder Bildfeldes, der Beleuchtungs- oder Projektionsoptik verlaufen. Soweit diese Strahlen im Winkelraum, soweit also die Randstrahlen der Beleuchtungswinkelverteilung, durch eine einfache geometrische Form, also z. B. einen exakten Kreis, eine Mehrzahl von Kreisen, ein Quadrat, eine Ellipse, ein Trapez, ein Rechteck, eine Sinus- oder eine Kosinusform, um die Hauptstrahlrichtung beschrieben werden können, liegt eine noch unkorrigierte Umfangskontur vor. Der Korrekturbetrag, um den die Umfangskontur der Korrekturblende von der sonstigen, unkorrigierten Umfangskontur abweicht, liegt insbesondere im Bereich eines Bruchteils des Durchmessers der teilweise abgeschatteten Quellbilder. Der Korrekturbetrag kann dabei insbesondere zwischen 1 % und 90 % des Quellbild-Durchmessers variieren. Bevorzugt ist ein Korrekturbetrag zwischen 10 % und 80 %, noch mehr bevorzugt zwischen 20 % und 70 %, noch mehr bevorzugt zwischen 30 % und 60 % und noch mehr bevorzugt zwischen 40 % und 50 % des Quellbild-Durchmessers.

Erfindungsgemäß wurde ferner erkannt, dass über den Blendenrand einer Korrekturblende Einfluss auf die Beleuchtungsparameter Telezentrie und Elliptizität genommen werden kann. Dies kann dazu genutzt werden, diese Parameter so zu optimieren, dass die Abweichung dieser Parameter von Vorgabewerten minimiert ist. Die Form des Blendenrandes kann also insbesondere zur Korrektur der Telezentrie und der Elliptizität der Beleuchtung des Objektfeldes vorgegeben werden. Insbesondere ist eine Anpassung einer Abschattung des Pupillenfacettenspiegels an verschiedene Geometrien von Strahlungsquellen und an verschiedene Beleuchtungssettings möglich. Die Abschattung kann direkt benachbart zum Pupillenfacettenspiegel erfolgen, sodass Einzelfacetten des Pupillenfacettenspiegels selbst abgeschattet werden. Alternativ ist es möglich, die Korrekturblende nicht benachbart zum Pupillenfacettenspiegel, sondern im Bereich einer zum Pupillenfacettenspiegel konjugierten Pupillenebene anzuordnen. In jedem dieser Fälle werden entweder einige Einzelfacetten oder einige diesen Einzelfacetten zugeordnete Quellbilder von ein und demselben Blendenrand teilweise abgeschattet.

Mit einem längs des gesamten Blendenrandes kontinuierlichen Korrekturverlauf lassen sich anspruchsvolle Anforderungen an die Beleuchtungsparameter Telezentrie und Elliptizität erfüllen. Der maximale Korrekturbetrag, mit dem der kontinuierliche Korrekturverlauf von einer unkorrigierten Umfangskontur abweicht, liegt insbesondere im Bereich eines Bruchteils des Durchmessers der teilweise abgeschatteten Quellbilder. Der Korrekturbetrag kann dabei insbesondere zwischen 1 % und 90 % des Quellbild-Durchmessers variieren. Bevorzugt ist ein Korrekturbetrag zwischen 10 % und 80 %, noch mehr bevorzugt zwischen 20 % und 70 %, noch mehr bevorzugt zwischen 30 % und 60 % und noch mehr bevorzugt zwischen 40 % und 50 % des Quellbild-Durchmessers.

Eine Vorgabe einer unkorrigierten Umfangskontur, insbesondere eines unkorrigierten Radius, der kontinuierlich um einen Korrekturbetrag abweicht, stellt einen Startwert für eine Optimierung zur Gestaltung des Blendenrand-Verlaufes der Korrekturblende dar. Ein entsprechendes Optimierverfahren lässt sich mit gut beherrschbarem Rechenaufwand durchführen. Alternativ ist auch eine stufenweise Abweichung der Umfangskontur der Korrekturblende von einer unkorrigierten Umfangskontur möglich. Der Korrekturbetrag kann dabei insbesondere zwischen 1 % und 90 % des Quellbild-Durchmessers variieren. Bevorzugt ist ein Korrekturbetrag zwischen 10 % und 80 %, noch mehr bevorzugt zwischen 20 % und 70 %, noch mehr bevorzugt zwischen 30 % und 60 % und noch mehr bevorzugt zwischen 40 % und 50 % des Quellbild-Durchmessers.

Eine einstellbare Korrekturblende mit einem Blendenrand, der in seiner Umfangskontur, insbesondere in seinem Radius, zumindest in einem Korrekturabschnitt einstellbar ist, ermöglicht eine Feinjustage und damit Feinoptimierung der Beleuchtungsparameter Telezentrie und Elliptizität.

Eine Korrekturblende, die eine einzige zentrale Durchgangsöffnung aufweist, die von genau einem Blendenrand begrenzt ist, hat einen besonders einfachen Aufbau. Mit einer derartigen Blende ist insbesondere ein konventionelles Setting mit vorgegebenem Füllgrad möglich.

Eine Korrekturblende, die eine ringförmige Durchgangsöffnung aufweist, die von einem inneren Blendenrand und einem äußeren Blendenrand begrenzt ist, gewährleistet ein hinsichtlich der Beleuchtungsparameter Telezentrie und Elliptizität korrigiertes annulares Beleuchtungssetting. Auch hier wird die Form mindestens eines der Blendenränder insbesondere zur Korrektur der Telezentrie und der Elliptizität der Beleuchtung vorgegeben.

Mit einer Korrekturblende mit einer Mehrzahl von Durchgangsöffnungen, die von einem äußeren Blenderand begrenzt sind, lässt sich ein korrigiertes Dipol-, Quadrupol- oder sonstiges Multipol-Setting erzeugen. Auch andere korrigierte Beleuchtungssettings sind möglich. Auch bei dieser Variante kann die Form mindestens eines der Blendenränder insbesondere zur Korrektur der Telezentrie und der Elliptizität der Beleuchtung vorgegeben werden.

Eine Projektionsbelichtungsanlage, die weiterhin eine EUV-Lichtquelle umfasst, ermöglicht eine besonders hohe Auflösung und damit die Übertragung sehr feiner Objektstrukturen. Die Nutzstrahlung der EUV-Licht- bzw. Strahlungsquelle hat eine Wellenlänge zum Beispiel zwischen 10 und 30 nm.

Eine weitere Aufgabe der Erfindung ist es, ein Betriebsverfahren für eine Projektionsbelichtungsanlage anzugeben, bei dem zwischen gleichzeitig telezentrie- und elliptizitätskorrigierten Beleuchtungen abhängig von verschiedenen EUV-Strahlungsquellen gewechselt werden kann.

Diese Aufgabe ist erfindungsgemäß gelöst durch ein Betriebsverfahren zum Betrieb einer Projektionsbelichtungsanlage gemäß Anspruch 8.

Je nach den Anforderungen zum Beispiel an den Lichtdurchsatz kann die Projektionsbelichtungsanlage z. B. mit verschiedenen EUV-Strahlungsquellen oder mit verschiedenen Kollektoren betrieben werden. Auch ein sowohl die Strahlungsquelle als auch den Kollektor umfassendes Beleuchtungsmodul kann ausgewechselt werden. Je nach der eingesetzten Bestrahlungsquelle, die im entsprechenden Beleuchtungsmodul untergebracht ist, wird eine hieran angepasste Korrekturblende verwendet. Auch zur Vorgabe verschiedener Beleuchtungssettings bei ein und derselben Strahlungsquelle kann die Korrekturblende ausgetauscht werden. Auch der Austausch des Beleuchtungssettings stellt daher das Auswechseln einer ersten Beleuchtungsgeometrie durch eine zweite Beleuchtungsgeometrie dar.

Durch eine Anpassung oder eine Auswechslung eines Korrekturelements zur Anpassung der Gleichmäßigkeit der Ausleuchtung über das Bildfeld, welches nachfolgend auch als Uniformity-Korrektur-element bezeichnet wird, kann eine optimierte Bildfeldbeleuchtung nach einer Auswechslung der Beleuchtungsgeometrie auch in Fällen gewährleistet werden, in denen der Beleuchtungsgeometrie-Wechsel die Uniformity, also die Gleichmä-βigkeit der Ausleuchtung, über das Bildfeld zunächst unerwünscht beeinflusst. Das Uniformity-Korrekturelement stellt dann sicher, dass die Uniformity über das Bildfeld innerhalb vorgegebener Grenzen bleibt. Beim Design der Korrekturblende und des Uniformity-Korrekturelements findet ggf. ein iterativer Prozess statt, bis Telezentrie, Elliptizität und Uniformity innerhalb vorgegebener Toleranzgrenzen liegen.

Beim Einsatz der erfindungsgemäßen Projektionsbelichtungsanlage bei der Herstellung eines mikrostrukturierten Bauteils ist eine höhere Strukturauflösung aufgrund der im Vergleich zum Stand der Technik besser kontrollierbaren Beleuchtungsparameter Telezentrie und Elliptizität möglich. Das erfindungsgemäße Verfahren zur Herstellung eines mikrostrukturierten Bauteils umfasst dabei die Verfahrensschritte gemäß Anspruch 10.

Zusätzlich kann das Verfahren auch derart weitergebildet sein, dass der Blendenrand der Korrekturblende zur teilweisen Abschattung des Beleuchtungs- und Abbildungslichts vor dem Projizieren so justiert wird, dass ein Verzeichnungsfehler, der durch Reflexion des Beleuchtungs- und Abbildungslichts an Komponenten der abbildenden optischen Baugruppe entsteht, zumindest teilweise kompensiert ist.

Die Vorteile eines derart weitergebildeten Verfahrens entsprechen denen, die vorstehend unter Bezugnahme auf die Projektionsbelichtungsanlage bereits erläutert wurden.

Ausführungsbeispiele der Erfindung werden nachfolgend anhand der Zeichnung näher erläutert. In dieser zeigen:

Fig. 1      schematisch einen Meridionalschnitt durch eine Projektionsbelichtungsanlage für die EUV-Projektions-Mikrolithographie;

Fig. 2      eine Aufsicht auf einen Feldfacettenspiegel einer Beleuchtungsoptik der Projektionsbelichtungsanlage nach Fig. 1 in vergrößertem Maßstab, wobei eine Energieverteilung auf der Oberfläche des Feldfacettenspiegels durch eine EUV-Strahlungsquelle angedeutet ist;

Fig. 3      eine Aufsicht auf einen Pupillenfacettenspiegel der Beleuchtungsoptik der Projektionsbelichtungsanlage nach Fig. 1 in vergrößertem Maßstab, wobei eine Energieverteilung auf der Oberfläche des Pupillenfacettenspiegels durch eine EUV-Strahlungsquelle angedeutet ist;

Fig. 4      eine scanintegrierte Ausleuchtung einer Eintrittspupille in der Feldmitte eines Objektfeldes, welches durch die Beleuchtungsoptik der Projektionsbelichtungsanlage beleuchtet wird;

Fig. 5      die Wirkung einer in oder benachbart zu einer Pupillenebene der Beleuchtungsoptik angeordneten Blende auf die Ausleuchtung nach Fig. 4;

Fig. 6      eine Energieverteilung einer ersten EUV-Strahlungsquelle der Projektionsbelichtungsanlage nach Fig. 1 in einem Zwischen- fokus der Beleuchtungsoptik;

Fig. 7      den Feldfacettenspiegel nach Fig. 2, wobei dort eine Energieverteilung auf der Oberfläche des Feldfacettenspiegels durch eine EUV-Strahlungsquelle nach Fig. 6 angegeben ist;

Fig. 8      eine Energieverteilung auf dem Pupillenfacettenspiegel der Beleuchtungsoptik, erzeugt durch eine EUV-Strahlungsquelle nach Fig. 6;

Fig. 9      die scanintegrierte Ausleuchtung der Eintrittspupille in der Feldmitte des Objektfeldes, erzeugt durch eine EUV-Lichtquelle nach Fig. 6;

Fig. 10      in einer zu Fig. 5 ähnlichen Darstellung die Wirkung einer in oder benachbart zu einer Pupillenebene der Beleuchtungsoptik angeordneten weiteren Ausführung einer Blende auf die Ausleuchtung nach Fig. 9, wobei neben einem Korrekturblendenverlauf auch ein Verlauf einer unkorrigierten Blende wiedergegeben ist;

Fig. 11 ein Polarkoordinaten-Diagramm, welches den Verlauf des inneren Blendenrandes der unkorrigierten und der korrigierten Blende nach Fig. 10 wiedergibt;

Fig. 12 die Abhängigkeit der uniformity über die Position des Objektfeldes bei unkorrigiertem und korrigiertem Blendenrandverlauf;

Fig. 13 die Abhängigkeit des Füllfaktors σ über die Position des Objektfeldes bei unkorrigiertem und korrigiertem Blendenrandverlauf;

Fig. 14 die Abhängigkeit der x-Telezentrie über die Position des Objektfeldes bei unkorrigiertem und korrigiertem Blendenrandverlauf;

Fig. 15 die Abhängigkeit der y-Telezentrie über die Position des Objektfeldes bei unkorrigiertem und korrigiertem Blendenrandverlauf;

Fig. 16 die Abhängigkeit der Elliptizität 0/90 über die Position des Objektfeldes bei unkorrigiertem und korrigiertem Blendenrandverlauf;

Fig. 17 die Abhängigkeit der Elliptizität -45/45 über die Position des Objektfeldes bei unkorrigiertem und korrigiertem Blendenrandverlauf;

Fig. 18 eine Energieverteilung einer EUV-Strahlungsquelle der Projektionsbelichtungsanlage nach Fig. 1 in einem Zwischenfokus der Beleuchtungsoptik bei einer weiteren Ausführung einer EUV-Strahlungsquelle;

Fig. 19 den Feldfacettenspiegel nach Fig. 2, wobei dort eine Energieverteilung auf der Oberfläche des Feldfacettenspiegels durch eine EUV-Strahlungsquelle nach Fig. 18 angegeben ist;

Fig. 20 eine Energieverteilung auf dem Pupillenfacettenspiegel der Beleuchtungsoptik, erzeugt durch eine EUV-Strahlungsquelle nach Fig. 18;

Fig. 21 die scanintegrierte Ausleuchtung der Eintrittspupille in der Feldmitte des Objektfeldes, erzeugt durch eine EUV-Lichtquelle nach Fig. 18;

Fig. 22 in einer zu Fig. 10 ähnlichen Darstellung die Wirkung einer in oder benachbart zu einer Pupillenebene der Beleuchtungsoptik angeordneten weiteren Ausführung einer Blende auf die Ausleuchtung nach Fig. 18;

Fig. 23 ein Polarkoordinaten-Diagramm, welches den Verlauf des inneren Blendenrandes einer unkorrigierten und einer korrigierten Blende nach Fig. 22 wiedergibt;

Fig. 24 die Abhängigkeit der uniformity über die Position des Objektfeldes bei unkorrigiertem und korrigiertem Blendenrandverlauf nach Fig. 22;

Fig. 25 die Abhängigkeit des Füllfaktors über die Position des Objektfeldes bei unkorrigiertem und korrigiertem Blendenrandverlauf nach Fig. 22;

Fig. 26 die Abhängigkeit der x-Telezentrie über die Position des Objektfeldes bei unkorrigiertem und korrigiertem Blendenrandverlauf nach Fig. 22;

Fig. 27 die Abhängigkeit der y-Telezentrie über die Position des Objektfeldes bei unkorrigiertem und korrigiertem Blendenrandverlauf nach Fig. 22;

Fig. 28 die Abhängigkeit der Elliptizität 0/90 über die Position des Objektfeldes bei unkorrigiertem und korrigiertem Blendenrandverlauf nach Fig. 22;

Fig. 29 die Abhängigkeit der Elliptizität -45/45 über die Position des Objektfeldes bei unkorrigiertem und korrigiertem Blendenrandverlauf nach Fig. 22;

Fig. 30 eine Aufsicht auf eine weitere Ausführung eines Feldfacettenspiegels zum Einsatz in einer Projektionsbelichtungsanlage nach Fig. 1, ausgeleuchtet mit einer EUV-Strahlungsquelle in Form eines Flächenstrahlers mit winkelabhängiger Abstrahlung;

Fig. 31 in einer zu Fig. 3 ähnlichen Darstellung die Ausleuchtung einer weiteren Ausführung eines Pupillenfacettenspiegels mit dem Flächenstrahler nach Fig. 30;

Fig. 32 in einer zu Fig. 4 ähnlichen Darstellung die scanintegrierte Ausleuchtung der Eintrittspupille in der Mitte des Objektfeldes, ausgeleuchtet mit dem Flächenstrahler nach Fig. 30;

Fig. 33 in einer zu Fig. 10 ähnlichen Darstellung die Wirkung einer in oder benachbart zu einer Pupillenebene der Beleuchtungsoptik angeordneten weiteren Ausführung einer Blende auf die Ausleuchtung nach Fig. 30;

Fig. 34 ein Polarkoordinaten-Diagramm, welches den Verlauf des inneren Blendenrandes der unkorrigierten und der korrigierten Blende nach Fig. 33 wiedergibt;

Fig. 35 die Abhängigkeit der uniformity über die Position des Objektfeldes bei unkorrigiertem und korrigiertem Blendenrandverlauf, ausgeleuchtet mit dem Flächenstrahler nach Fig. 30;

Fig. 36 die Abhängigkeit des Füllfaktors über die Position des Objektfeldes bei unkorrigiertem und korrigiertem Blendenrandverlauf, ausgeleuchtet mit dem Flächenstrahler nach Fig. 30;

Fig. 37 die Abhängigkeit der x-Telezentrie über die Position des Objektfeldes bei unkorrigiertem und korrigiertem Blendenrandverlauf, ausgeleuchtet mit dem Flächenstrahler nach Fig. 30;

Fig. 38 die Abhängigkeit der y-Telezentrie über die Position des Objektfeldes bei unkorrigiertem und korrigiertem Blendenrandverlauf, ausgeleuchtet mit dem Flächenstrahler nach Fig. 30;

Fig. 39 die Abhängigkeit der Elliptizität 0/90 über die Position des Objektfeldes bei unkorrigiertem und korrigiertem Blenden-Randverlauf, ausgeleuchtet mit dem Flächenstrahler nach Fig. 30;

Fig. 40 die Abhängigkeit der Elliptizität -45/45 über die Position des Objektfeldes bei unkorrigiertem und korrigiertem Blenden- randverlauf, ausgeleuchtet mit dem Flächenstrahler nach Fig. 30;

Fig. 41 in einer zu Fig. 10 ähnlichen Darstellung einen unkorrigierten und einen korrigierten inneren und äußeren Blendenrand einer Ring-Korrekturblende und ihre Wirkung auf eine weitere Ausführung eines Pupillenfacettenspiegels zum Einsatz in einer Projektionsbelichtungsanlage nach Fig. 1 ;

Fig. 42 ein Polarkoordinaten-Diagramm, welches den Verlauf des inneren Blendenrandes der unkorrigierten und der korrigierten Blende nach Fig. 41 wiedergibt;

Fig. 43 die Abhängigkeit der x-Telezentrie über die Position des Objektfeldes bei unkorrigiertem und korrigiertem Blendenrandverlauf, bei Einsatz der unkorrigierten bzw. der korrigierten Korrekturblende nach Fig. 41;

Fig. 44 die Abhängigkeit der y-Telezentrie über die Position des Objektfeldes bei unkorrigiertem und korrigiertem Blendenrandverlauf, bei Einsatz der unkorrigierten bzw. der korrigierten Korrekturblende nach Fig. 41;

Fig. 45 die Abhängigkeit der Elliptizität 0/90 über die Position des Objektfeldes bei unkorrigiertem und korrigiertem Blendenrandverlauf, bei Einsatz der unkorrigierten bzw. der korrigierten Korrekturblende nach Fig. 41;

Fig. 46 die Abhängigkeit der Elliptizität -45/45 über die Position des Objektfeldes bei unkorrigiertem und korrigiertem Blenden-Randverlauf, bei Einsatz der unkorrigierten bzw. der korrigierten Korrekturblende nach Fig. 41;

Fig. 47 in einer zu Fig. 1 ähnlichen Darstellung eine Projektionsbelichtungsanlage für die EUV-Projektions- Mikrolithographie mit einem zusätzlichen Korrekturelement; und

Fig. 48 einen Feldfacettenspiegel zum Einsatz in einer Beleuchtungsoptik der Projektionsbelichtungsanlage nach Fig. 47 zusammen mit dem Korrekturelement vergrößert in einer zu Fig. 2 ähnlichen Aufsicht.

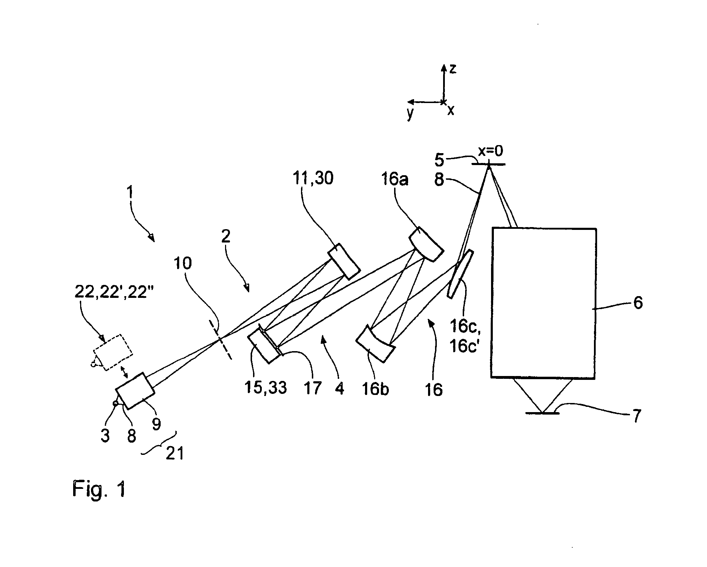

Fig. 1 zeigt schematisch in einem Meridionalschnitt eine Projektionsbelichtungsanlage 1 für die Mikrolithographie. Ein Beleuchtungssystem 2 der Projektionsbelichtungsanlage 1 hat neben einer Strahlungsquelle 3 eine Beleuchtungsoptik 4 zur Belichtung eines Objektfeldes in einer Objektebene 5. Belichtet wird hierbei ein im Objektfeld angeordnetes und in der Zeichnung nicht dargestelltes Retikel. Eine Projektionsoptik 6 dient zur Abbildung des Objektfeldes in ein Bildfeld in einer Bildebene 7. Abgebildet wird eine Struktur auf dem Retikel auf eine lichtempfindliche Schicht eines im Bereich des Bildfeldes in der Bildebene 7 angeordneten Wafers, der in der Zeichnung ebenfalls nicht dargestellt ist.

Zur Erleichterung der Darstellung ist in der Figur 1 ein kartesisches xyz-Koordinatensystem eingezeichnet. Die x-Richtung verläuft in der Fig. 1 senkrecht zur Zeichenebene in diese hinein. Die y-Richtung, nämlich die Scanrichtung von Retikel und Wafer, verläuft in der Fig. 1 nach links. Die z-Richtung läuft in der Fig. 1 nach oben. Die dargestellte EUV-Strahlung 8 trifft auf die Objektebene 5 bei x = 0.

Bei der Strahlungsquelle 3 handelt es sich um eine EUV-Strahlungsquelle mit einer emittierten Nutzstrahlung im Bereich zwischen 10 nm und 30 nm. EUV-Strahlung 8, die von der Strahlungsquelle 3 ausgeht, wird von einem Kollektor 9 gebündelt. Ein entsprechender Kollektor ist aus der EP 1 225 481 A bekannt. Nach dem Kollektor 9 propagiert die EUV-Strahlung 8 durch eine Zwischenfokusebene 10, bevor sie auf einen Feldfacettenspiegel 11 trifft. Die EUV-Strahlung 8 wird nachfolgend auch als Beleuchtungs- und Abbildungslicht bezeichnet.

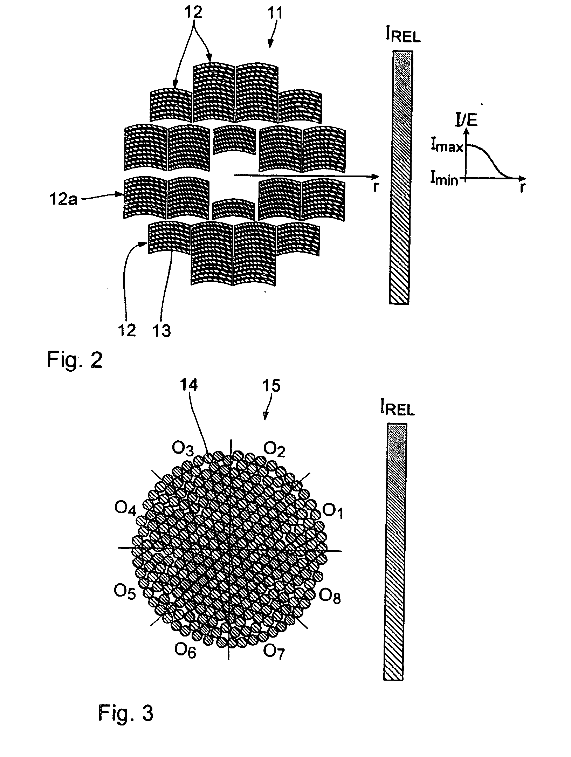

Fig. 2 zeigt eine vergrößerte Aufsicht auf den Feldfacettenspiegel 11. Dieser besteht aus einer Mehrzahl von spalten- und zeilenweise angeordneten Facettengruppen 12, die wiederum jeweils aus einer Mehrzahl gebogener Einzelfacetten 13 bestehen. Der Feldfacettenspiegel 11 ist aus mehreren unterschiedlichen Typen von Facettengruppen 12 aufgebaut, die sich in der Anzahl der Einzelfacetten 13 unterscheiden. Die in der Fig. 2 links unten dargestellte Feldfacettengruppe 12a ist beispielsweise in 9 Einzelfacetten 13 unterteilt. Andere Feldfacettengruppen 12 haben mehr oder weniger Einzelfacetten 13. Aufgrund einer durch den Kollektor 9 erzeugten Mittenabschattung weist ein zentraler Bereich des Feldfacettenspiegels 11 keine Feldfacetten auf.

Die von dem Feldfacettenspiegel 11 reflektierte EUV-Strahlung 8 ist aus einer Vielzahl von Strahlungs-Teilbündeln aufgebaut, wobei jedes Teilbündel von einer bestimmten Einzelfacette 13 reflektiert wird. Jedes Teilbündel trifft wiederum auf eine dem Teilbündel zugeordnete Einzelfacette 14 (vgl. Fig. 3) eines Pupillenfacettenspiegels 15. Die Pupillen-Einzelfacetten 14 sind rund und dicht gepackt angeordnet, sodass sie insbesondere im Zentrum des Pupillenfacettenspiegels 15 als hexagonal dichteste Packung vorliegen. Mit dem Feldfacettenspiegel 11 werden am Ort der Einzelfacetten 14 des Pupillenfacettenspiegels 15 sekundäre Lichtquellen erzeugt. Der Pupillenfacettenspiegel 15 ist in einer Ebene der Beleuchtungsoptik 4 angeordnet, die mit einer Pupillenebene der Projektionsoptik 6 zusammenfällt oder zu dieser optisch konjugiert ist. Die Intensitätsverteilung der EUV-Strahlung 8 auf dem Pupillenfacettenspiegel 15 ist daher direkt korreliert mit einer Beleuchtungswinkelverteilung der Beleuchtung des Objektfeldes in der Objektebene 5.

Mit Hilfe des Pupillenfacettenspiegels 15 und einer abbildenden optischen Baugruppe in Form einer Übertragungsoptik 16 werden die Feld-Einzelfacetten 13 des Feldfacettenspiegels 11 in die Objektebene 5 abgebildet. Die Übertragungsoptik 16 weist drei dem Pupillenfacettenspiegel 15 nachgeordnete reflektierende Spiegel 16a, 16b und 16c auf.

Die Feld-Einzelfacetten 13 haben beim Feldfacettenspiegel 11 die Form des auszuleuchtenden Objektfeldes. Derartige Feldfacetten sind beispielsweise aus der US 6,452,661 und der US 6,195,201 bekannt.

Benachbart zur reflektierenden Oberfläche des Pupillenfacettenspiegels 15 angeordnet ist eine Korrekturblende 17. EUV-Strahlung 8, die die Beleuchtungsoptik 4 durchläuft, muss die Korrekturblende 17 passieren. Beim Strahlengang der EUV-Strahlung 8 nach Fig. 1 passiert die EUV-Strahlung 8 die Korrekturblende 17 zweimal. EUV-Strahlung wird von der Korrekturblende 17 so geblockt, dass nur durch die Durchgangsöffnung 18 hindurchtretende EUV-Strahlung von der Korrekturblende 17 hindurchgelassen und die sonstige EUV-Strahlung 8 geblockt wird.

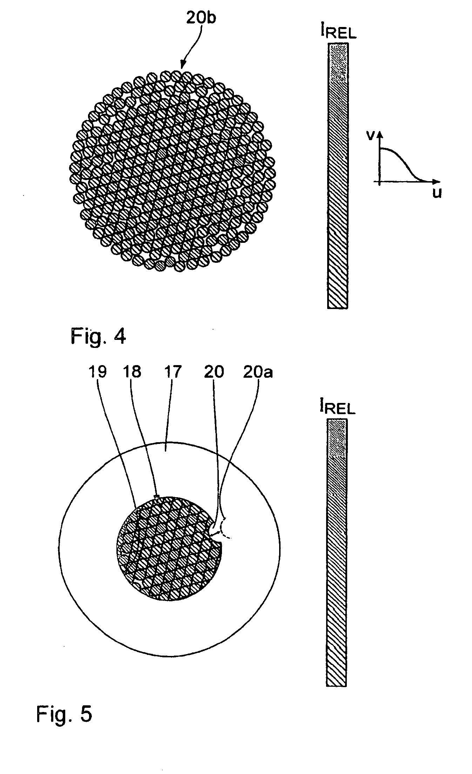

Fig. 5 zeigt eine erste Ausführung der Korrekturblende 17. Diese hat eine zentrale Durchgangsöffnung 18, die von genau einem Blendenrand 19 begrenzt ist. Zwischen der Zwei-Uhr-Position und der Drei-Uhr-Position weist der Blendenrand 19 einen teilkreisförmig in die Durchgangsöffnung 18 hineinragenden Korrekturabschnitt 20 auf.

Abgesehen vom Korrekturabschnitt 20 ist die Durchgangsöffnung 18 der Korrekturblende 17 kreisrund. Nur im Bereich des Korrekturabschnitts 20 weicht die Umfangskontur, im vorliegenden Fall also der Radius, der Durchgangsöffnung 18 vom sonstigen Radius der Durchgangsöffnung 18 ab und ist dort kleiner.

Fig. 5 zeigt zudem die Wirkung der Korrekturblende 17 auf die Ausleuchtung eines mittleren Objekt-Feldpunktes in der Objektebene 5. Dargestellt ist im Inneren der Durchgangsöffnung 18 eine scanintegrierte Ausleuchtung einer Eintrittspupille eines mittleren Objektfeldpunktes (x = 0) in der Objektebene 5. Die gesamte scanintegrierte Ausleuchtung dieses Objektfeldpunktes ohne Korrekturblende 17 zeigt Figur 4. Dort ist also dargestellt, aus welchen Beleuchtungsrichtungen, repräsentiert durch die Pupillen-Einzelfacetten 14, Strahlungs-Teilbündel der EUV-Strahlung 8 mit welchen Energien oder Intensitäten auf einen Punkt des Retikels in der Objektebene 5 treffen, der in y-Richtung bei x = 0 durch die Objektebene gescannt wird.

Die Projektionsbelichtungsanlage 1 ist vom Scanner-Typ. Dies bedeutet, dass während des Betriebs der Projektionsbelichtungsanlage 1 sowohl das Retikel in der Objektebene 5 als auch der Wafer in der Bildebene 7 in y-Richtung kontinuierlich bewegt werden.

In der Fig. 2 ist zudem dargestellt, mit welchen Intensitäten bzw. Energien (I/E) die Facettengruppen 12 der Einzelfacetten 13 mit der EUV-Strahlung 8 beaufschlagt werden. Bedingt durch die räumliche Verteilung der Strahlungsquelle 3 und die abbildende Wirkung des Kollektors 9 ist die Intensitäts- bzw. Energiebeaufschlagung des Feldfacettenspiegels 11 mit der EUV-Strahlung 8 nicht perfekt homogen, sondern differiert über den Radius r des Feldfacettenspiegels 11, wie im in der Fig. 2 rechten I/r-Diagramm dargestellt, zwischen einem Maximalwert $I_{max}$ und einem Mini-malwert $I_{min}$. Zwischen der Aufsicht auf den Feldfacettenspiegel 11 und dem I/r-Diagramm ist in der Fig. 2 ein senkrechter Balken $I_{rel}$ dargestellt, der in verschiedene Schraffur-Bereiche unterteilt ist. Die relative Intensität $I_{rel}$ ist entsprechend dieser Schraffuren auf den Feld-Einzelfacetten 13 umso höher, je dichter die Schraffur ist. Dies gilt entsprechend für die nachfolgenden Figuren, bei denen ein entsprechender $I_{rel}$-Balken dargestellt ist.

Der Maximalwert wird dabei im Bereich kleiner Radien, also im Innenbereich des Feldfacettenspiegels 11, und der Minimalwert wird im Bereich großer Radien, also im äußeren Bereich des Feldfacettenspiegels 11, erreicht. Je nach den Spezifikationen der Strahlungsquelle 3 und des Kollektors 9 kann das Verhältnis $I_{max}$ / $I_{min}$ verschieden sein. Verhältnisse $I_{max}$ / $I_{min}$ zwischen 1,05 und 10 sind in der Praxis möglich. Das in der Fig. 2 rechts dargestellte Diagramm zeigt schematisch den Verlauf der Intensität bzw. Energie I/E über den Radius r. Diese Intensität bzw. Energie nimmt mit größer werdendem Radius kontinuierlich ab.

Aufgrund der verschiedenen Energien bzw. Intensitäten, die auf die Einzelfacetten 13 des Feldfacettenspiegels 11 treffen, werden auch die Pupillen-Einzelfacetten 14 mit unterschiedlichen Energien bzw. Intensitäten transportierenden Strahlungs-Teilbündeln der EUV-Strahlung 8 beaufschlagt. Dies ist in der Fig. 3 durch unterschiedliche Kennzeichnungen der Pupillen-Einzelfacetten 14 gekennzeichnet. Da die Feld-Einzelfacetten 13 derart ausgerichtet sind, dass benachbarte Feld-Einzelfacetten 13 weiter auseinander liegende Pupillen-Einzelfacetten 14 beleuchten, sind benachbarte Pupillen-Einzelfacetten 14 in der Regel mit Strahlungs-Teilbündeln der EUV-Strahlung 8 mit unterschiedlicher Energie bzw. Intensität beaufschlagt.

Im Idealfall ist die Beaufschlagung der Pupillen-Einzelfacetten 14 durch die Strahlungs-Teilbündel derart, dass der Energie- bzw. Intensitäts-Schwerpunkt einer Superposition aller Strahlungs-Teilbündel genau im Zentrum der Eintrittspupille der Projektionsoptik 6 liegt und dass beliebige Flächenabschnitte, insbesondere beliebige Quadranten oder allgemeiner beliebige Sektoren der Eintrittspupille der Projektionsoptik 6 mit gleicher Energie bzw. Intensität beaufschlagt werden.

Für die Schwerpunktlage der Energie bzw. Intensität wird als Messgröße die Telezentrie herangezogen.

In jedem Feldpunkt des ausgeleuchteten Objektfeldes ist ein Schwerstrahl eines diesem Feldpunkt zugeordneten Lichtbüschels definiert. Der Schwerstrahl hat dabei die energiegewichtete Richtung des von diesem Feldpunkt ausgehenden Lichtbüschels. Im Idealfall verläuft bei jedem Feldpunkt der Schwerstrahl parallel zum von der Beleuchtungsoptik 4 bzw. der Projektionsoptik 6 vorgegebenen Hauptstrahl.

Die Richtung des Hauptstrahls $\bar{s}_0$ (x,y) ist anhand der Designdaten der Beleuchtungsoptik 4 bzw. der Projektionsoptik 6 bekannt. Der Hauptstrahl ist an einem Feldpunkt definiert durch die Verbindungslinie zwischen dem Feldpunkt und dem Mittelpunkt der Eintrittspupille der Projektionsoptik 6. Die Richtung des Schwerstrahls an einem Feldpunkt x, y im Objektfeld in der Objektebene 5 berechnet sich zu:

$$\vec{s}(x, y) = \frac{1}{\tilde{E}(x, y)} \int du dv \begin{pmatrix} u \\ v \end{pmatrix} E(u, v, x, y).$$

E (u,v,x,y) ist die Energieverteilung für den Feldpunkt x,y in Abhängigkeit von den Pupillenkoordinaten u,v, also in Abhängigkeit vom Beleuchtungswinkel, den der entsprechende Feldpunkt x, y sieht.

$\tilde{E}(x, y) = \int du dv E(u, v, x, y)$ ist dabei die Gesamtenergie, mit der der Punkt x,y beaufschlagt wird.

Im in der Fig. 3 dargestellten Beispiel sieht z. B. ein mittiger Objektfeldpunkt $x_0$, $y_0$ die Strahlung von Strahlungs-Teilbündeln aus Richtungen u,v, die durch die Position der jeweiligen Pupillen-Einzelfacetten 14 definiert ist. Der Schwerstrahl s verläuft bei dieser Beleuchtung nur dann längs des Hauptstrahls, wenn sich die verschiedenen Energien bzw. Intensitäten der den Pupillen-Einzelfacetten 14 zugeordneten Strahlungs-Teilbündel zu einer über alle Pupillen-Einzelfacetten 14 integrierten Schwerstrahlrichtung zusammensetzen, die parallel zur Hauptstrahlrichtung verläuft. Dies ist nur im Idealfall so. In der Praxis existiert eine Abweichung zwischen der Schwerstrahlrichtung $\bar{s}(x, y)$ und der Haupt-strahlrichtung $\bar{s}_0$(x,y), die als Telezentriefehler $\bar{t}(x, y)$ bezeichnet wird:

$$\vec{t}(x,y) = \vec{s}(x,y) - \vec{s}_0(x,y)$$

Korrigiert werden muss im praktischen Betrieb der Projektionsbelichtungsanlage 1 nicht der statische Telezentriefehler bei einem bestimmten Objektfeld, sondern der bei $x = x_0$ scanintegrierte Telezentriefehler. Dieser ergibt sich zu:

$$\vec{T}(x_0) = \frac{\int dy \widetilde{E}(x_0,y)\vec{t}(x_0,y)}{\int dy \widetilde{E}(x_0,y)}.$$

Es wird also der Telezentriefehler korrigiert, den ein durch das Objektfeld in der Objektebene 5 während des Scannens laufender Punkt (x, z. B. $x_0$) auf dem Retikel ernergiegewichtet aufintegriert erfährt. Unterschieden wird dabei zwischen einem x-Telezentriefehler und einem y-Telezentriefehler. Der x-Telezentriefehler ist als Abweichung des Schwerstrahls vom Hauptstrahl senkrecht zur Scanrichtung definiert. Der y-Telezentriefehler ist als die Abweichung der Schwerstrahls vom Hauptstrahl in Scanrichtung definiert.

Fig. 4 zeigt die Energieverteilung 20b, mit der der Punkt x=0, also in der Mitte des Objektfeldes, während des Scans beaufschlagt wird in Abhängigkeit der Winkel u, v. Das heisst dargestellt ist E'(u,v,x) = $\int dyE(u, v, x, y)$ für x=0, also für die Mitte des Objektfeldes.

Fig. 5 zeigt die Wirkung der Korrekturblende 17 auf diese scanintegrierte Ausleuchtung nach Fig. 4. Der Korrekturabschnitt 20 deckt abschnittsweise Pupillen-Einzelfacetten 14 ab, die zur scanintegrierten Ausleuchtung mit hohen Energien bzw. Intensitäten beitragen. Durch den Korrekturabschnitt 20 ist also eine effektive Korrektur der Schwerstrahlrichtung und damit des Telezentriefehlers gegeben.

Neben dem Telezentriefehler ist die Elliptizität eine weitere Messgröße zur Beurteilung der Qualität der Ausleuchtung des Objektfeldes in der Objektebene 5. Die Bestimmung der Elliptizität erlaubt dabei eine genauere Aussage über die Verteilung der Energie bzw. Intensität über die Eintrittspupille der Projektionsoptik 6. Hierzu wird die Eintrittspupille in acht Oktanten unterteilt, die in der Fig. 3 wie mathematisch üblich entgegen dem Uhrzeigersinn von $O_1$ bis $O_8$ durchnumeriert sind. Der Energie- bzw. Intensitätsbeitrag, den die Oktanten $O_1$ bis $O_8$ der Eintrittspupille zur Beleuchtung eines Feldpunktes beitragen, wird nachfolgend als Energie- bzw. Intensitätsbeitrag $I_1$ bis $I_8$ bezeichnet.

Man bezeichnet als -45˚/45˚-Elliptizität nachfolgende Größe

$$E_{-45°/45°} = \frac{I1 + I2 + I5 + I6}{I3 + I4 + I7 + I8}$$

und als 0˚/90˚-Elliptizität nachfolgende Größe

$$E_{0°/90°} = \frac{I1 + I8 + I4 + I5}{I2 + I3 + I6 + I7}.$$

Entsprechend zum vorstehend in Bezug auf den Telezentriefehler Ausgeführten kann auch die Elliptizität, wie im Beispiel nach Fig. 3, für einen bestimmten Objektfeldpunkt $x_0$, $y_0$ oder aber auch für eine scanintegrierte Ausleuchtung (x = $x_0$, y-integriert) bestimmt werden.

Die Wirkung des Korrekturabschnitts 20 der Korrekturblende 17 ist derart, dass Objektfeldpunkte, die von der die Korrekturblende 17 passierenden EUV-Strahlung 8 beleuchtet werden, scanintegriert mit einer Schwerstrahlrichtung parallel zum Hauptstrahl beleuchtet werden (Telezentriefehler = 0) und von allen acht Oktanten $O_1$ bis $O_8$ der Eintrittspupille mit der gleichen Energie bzw. Intensität beaufschlagt werden ($E_{-45˚/45˚}$ = $E_{0˚/90˚}$ = 1).

Bei der Projektionsbelichtungsanlage 1 kann ein Beleuchtungsmodul 21, umfassend die Strahlungsquelle 3 und den Kollektor 9, gegen ein Austausch-Beleuchtungsmodul 22 mit einer anderen Strahlungsquelle und einem anderen, hieran angepassten Kollektor, ausgewechselt werden. Bei einer nicht dargestellten Ausführungsform der Projektionsbelichtungsanlage 1 kann auch nur die Strahlungsquelle 3 oder nur der Kollektor 9 getauscht werden, wobei die jeweils andere Komponente 9, 3 in der Projektionsbelichtungsanlage 1 verbleibt.

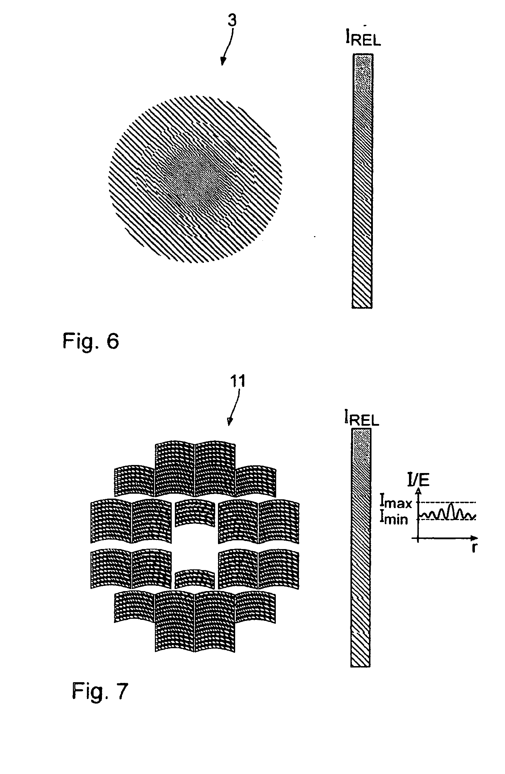

Fig. 6 zeigt eine Energieverteilung, erzeugt durch das Austausch-Beleuchtungsmodul 22, in der Zwischenfokusebene 10. Die zugehörige Strahlungsquelle 3 hat die Form eines Ellipsoids mit einer langen Hauptachse und zwei gleich langen kurzen Hauptachsen. Die lange Achse liegt dabei in Strahlrichtung zwischen dem Kollektor 9 und dem Feldfacettenspiegel 11.

Fig. 7 zeigt die Verteilung der Intensität bzw. Energie I/E über den Radius des Feldfacettenspiegels 11, erzeugt durch Beleuchtung mit dem Austausch-Beleuchtungsmodul 22. Die Energie bzw. Intensität oszilliert über den Radius r des Feldfacettenspiegels 11 zwischen einer minimalen Energie bzw. Intensität $I_{min}$ und einer maximalen Energie bzw. Intensität $I_{max}$.

Für das Verhältnis $I_{max}/I_{min}$ gilt, was vorstehend im Zusammenhang mit der Verteilung nach Fig. 2 erläutert wurde.

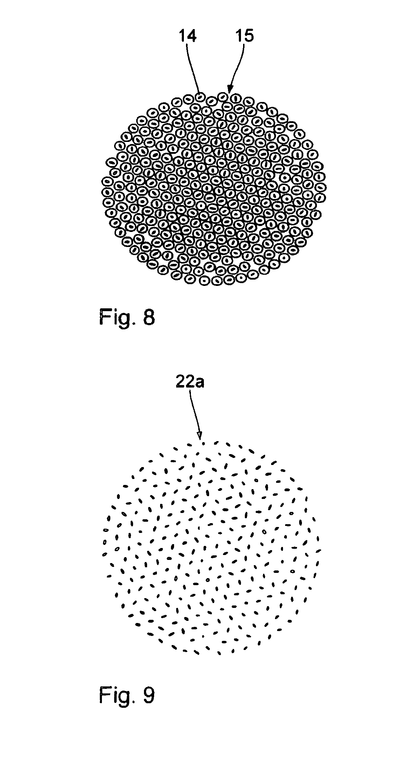

Die Ausleuchtung des Feldfacettenspiegels 11 gemäß Fig. 7 führt zu einer Ausleuchtung des Pupillenfacettenspiegels 15, die in der Fig. 8 schematisch angedeutet ist. Innerhalb der runden Pupillen-Facetten 14 ist jeweils nur ein zentraler Abschnitt dieser Einzelfacetten 14 ausgeleuchtet. Diese zentrale Ausleuchtung der Einzelfacetten 14 wird auch als Quellbild bezeichnet. Scanintegriert ergibt sich in der Eintrittspupille der Projektionsoptik 6 eine Ausleuchtung 22a für einen Objektfeldpunkt bei x = 0, die in der Fig. 9 dargestellt ist.

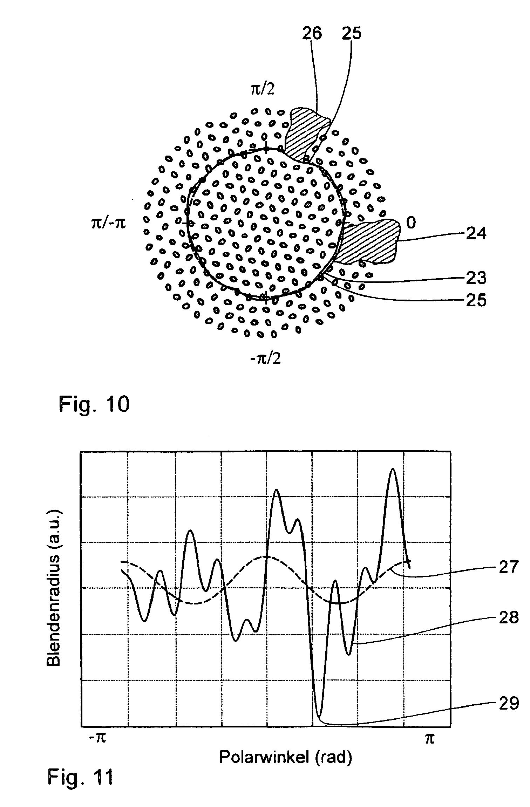

Fig. 10 zeigt gestrichelt einen gesamten inneren Blendenrand 23 einer lediglich in einem Umfangsabschnitt bereichsweise dargestellten unkorrigierten Blende 24 und durchgezogen einen gesamten inneren Blendenrand 25 einer ebenfalls lediglich in einem Umfangsabschnitt bereichsweise dargestellten Korrekturblende 26.

Überhöht ist der exakte Radiusverlauf der Blendenränder 23 und 25 in Polarkoordinaten in der Fig. 11 dargestellt. Ein kosinusförmiger gestrichelter Radiusverlauf 27 gehört dabei zur unkorrigierten Blende 24. Ein im Vergleich zum Radiusverlauf 27 stärker und hochfrequenter modulierter durchgezogener Radiusverlauf 28 gehört zur Korrekturblende 26. Die Radiusverläufe nach Fig. 11 beginnen bei -π an einem Umfangspunkt, der in der Fig. 10 in der 9-Uhr-Position liegt, wobei nachfolgend der innere Blendenrand 23, 25 entgegen dem Uhrzeigersinn durchlaufen wird. Ein charakteristisches globales Minimum 29 des Radiusverlaufs 28 der Korrekturblende 26 kurz vor π/2 findet sich in der Darstellung nach Fig. 10 etwa in 1-Uhr-Position dort, wo die Korrekturblende 26 bereichsweise dargestellt ist.

Die Umfangskontur einer unkorrigierten Blende 24 stellt den Startpunkt eines Optimierungsalgorithmus zur Berechnung der Form der Korrekturblende 26 dar, bei der sowohl der Telezentriefehler als auch der Elliptizitätsfehler möglichst günstige, niedrige Werte einnehmen. Der Verlauf der Korrekturblende 26 weicht längs des Blendenrandes von der unkorrigierten Umfangskontur der Blende 24 kontinuierlich um einen Korrekturbetrag ab.

Mit den Blenden 24, 26 lässt sich ein konventionelles Beleuchtungssetting mit σ = 0,5 realisieren. Dies bedeutet, dass nur der halbe maximal mögliche Apertur-Radius der Projektionsoptik 6 ausgeleuchtet wird.

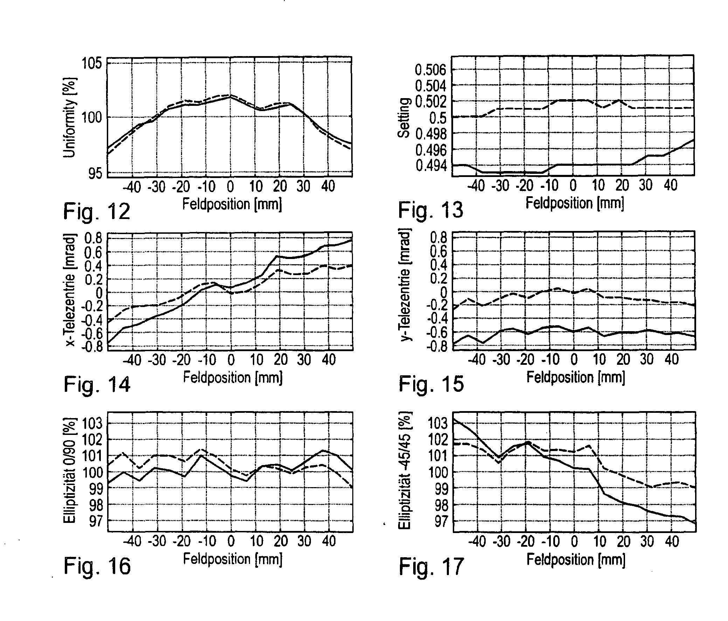

Ein Performancevergleich der Projektionsbelichtungsanlage 1 mit der unkorrigierten Blende 24 einerseits und der Korrekturblende 26 ist in den Fig. 12 bis 17 anhand von Parameter-Diagrammen dargestellt. Durchgezogen ist jeweils der Parameterverlauf bei Verwendung der unkorrigierten Blende 24 und gestrichelt der Parameterverlauf bei Verwendung der Korrekturblende 26 dargestellt. Dargestellt sind die Parameter jeweils scanintegriert zwischen x = -50 mm und x = 50 mm.

Fig. 12 zeigt scanintegriert den Verlauf der uniformity über die Feldposition zwischen x = -50 mm und x = +50 mm. Die uniformity stellt dabei das Integral der Energie bzw. Intensität dar, die scanintegriert jeder Objektfeldpunkt sieht, unabhängig von der Richtung, aus der die Strahlung einfällt.

Fig. 13 zeigt den σ-Wert. Deutlich ist zu sehen, dass bei Einsatz der Korrekturblende 26 das Setting über den gesamten Feldbereich mit kleinen Abweichungen konstant zwischen 0,5 und 0,502 gehalten werden kann.

Fig. 14 zeigt die x-Telezentrie in mrad. Die x-Telezentrie ist definiert als die Abweichung des Schwerstrahls vom Hauptstrahl in Richtung x, also senkrecht zur Scanrichtung. Deutlich zu erkennen ist, dass der Variationsbereich der x-Telezentrie bei Verwendung der Korrekturblende 26 gegenüber dem Variationsbereich der x-Telezentrie bei Verwendung der unkorrigierten Blende 24 deutlich reduziert ist. Die x-Telezentrie variiert bei Verwendung der Korrekturblende 26 über das gesamte Objektfeld lediglich zwischen -0,4 und +0,4 mrad.

Fig. 15 zeigt die y-Telezentrie, ebenfalls in mrad. Die y-Telezentrie ist definiert als die Abweichung des Schwerstrahls vom Hauptstrahl in der Scanrichtung y. Die y-Telezentrie kann praktisch über das gesamte Feld bei Verwendung der Korrekturblende 26 zwischen -0,2 und 0 mrad gehalten werden.

Fig. 16 zeigt die Elliptizität $E_{0°/90°}$ in Prozent. Bei diesem Wert, der auch schon beim Einsatz der unkorrigierten Blende 24 gut ist, wird durch Verwendung der Korrekturblende 26 kein wesentlicher Unterschied erzeugt.

Fig. 17 zeigt den Verlauf der Elliptizität $E_{-45°/45°}$ über das Feld. Deutlich ist zu sehen, wie der Einsatz der Korrekturblende 26 im Vergleich zur unkorrigierten Blende 24 eine deutliche Verringerung der Bandbreite der Elliptizitätswerte bewirkt. Die Elliptizität variiert bei Verwendung der Korrekturblende 26 nur noch zwischen 99 und 102 %.

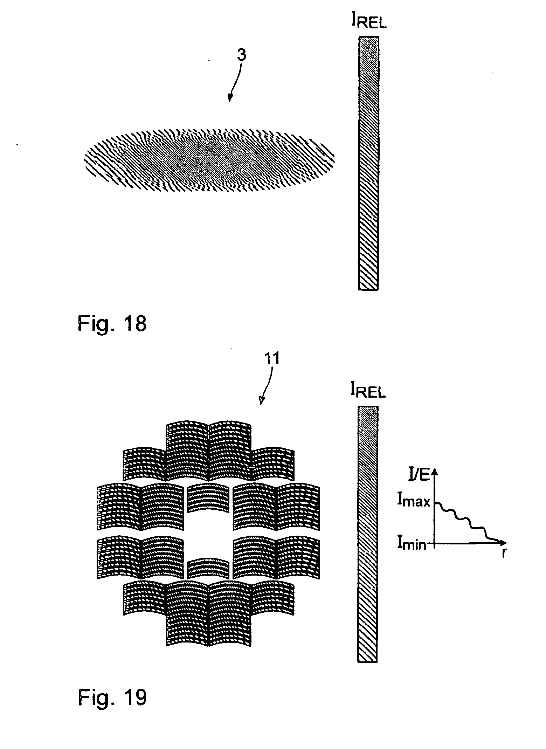

Anhand der Fig. 18 bis 29 wird nachfolgend eine weitere Ausführung eines Austausch-Beleuchtungsmoduls 22' sowie einer weiteren Korrekturblende beschrieben. Komponenten, die denen entsprechen, die vorstehend schon unter Bezugnahme auf die Fig. 1 bis 17 erläutert wurden, tragen die gleichen Bezugsziffern und werden nicht nochmals im Einzelnen diskutiert.

Bei der Ausführung nach den Fig. 18 bis 29 wird nur die Strahlungsquelle 3 getauscht, nicht aber der Kollektor 9.

Fig. 18 zeigt den Verlauf der Energie bzw. Intensität bei Verwendung des Austausch-Beleuchtungsmoduls 22' in der Zwischenfokusebene 10. Die Strahlungsquelle 3 ist beim Austausch-Beleuchtungsmodul 22' ein Strahler in Form eines Ellipsoids, dessen lange Hauptachse senkrecht zur Strahlrichtung zwischen dem Kollektor 9 und dem Feldfacettenspiegel 11 liegt.

Bei Verwendung des Austausch-Beleuchtungsmoduls 22' resultiert eine Ausleuchtung des Feldfacettenspiegels 11 mit einer Energie bzw. Intensität I/E, die in der Fig. 19 qualitativ im rechten Diagramm dargestellt ist. Die Energie bzw. Intensität sinkt wellen- bzw. stufenförmig zwischen einer höheren Energie bzw. Intensität $I_{max}$ und einer niedrigeren Energie bzw. Intensität $I_{min}$. Für das Verhältnis der beiden Intensitäten gilt, was vorstehend im Zusammenhang mit den Intensitäten $I_{min}$, $I_{max}$ nach Fig. 2 erläutert wurde.

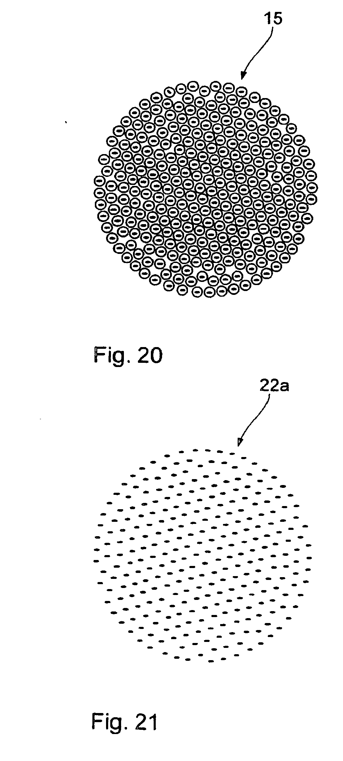

Fig. 20 zeigt entsprechend Fig. 8 schematisch die Ausleuchtung des Pupillenfacettenspiegels 15 beim Einsatz des Austausch-Beleuchtungsmoduls 22'.

Fig. 21 zeigt entsprechend Fig. 9 die scanintegrierte Beleuchtung eines Objektfeldpunktes in der Feldmitte (x = 0) durch den Pupillenfacettenspiegel 15.

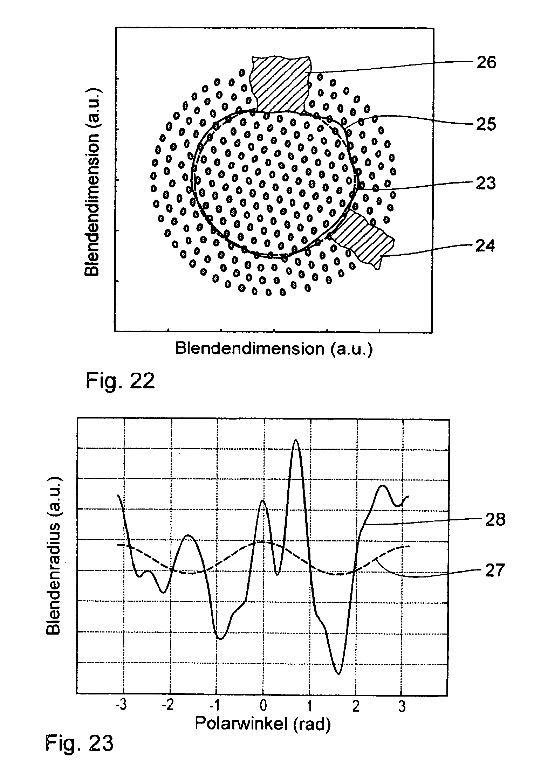

Fig. 22 zeigt entsprechend zur Darstellung nach der Fig. 10 die unkorrigierte Blende 24 und die abgestimmt auf das Austausch-Beleuchtungsmodul 22' gestaltete Korrekturblende 26. Fig. 23 zeigt entsprechend zur Fig. 11 den Polarkoordinatenverlauf der Radien der inneren Blendenränder 23 (unkorrigierte Blende 24) und 25 (Korrekturblende 26).

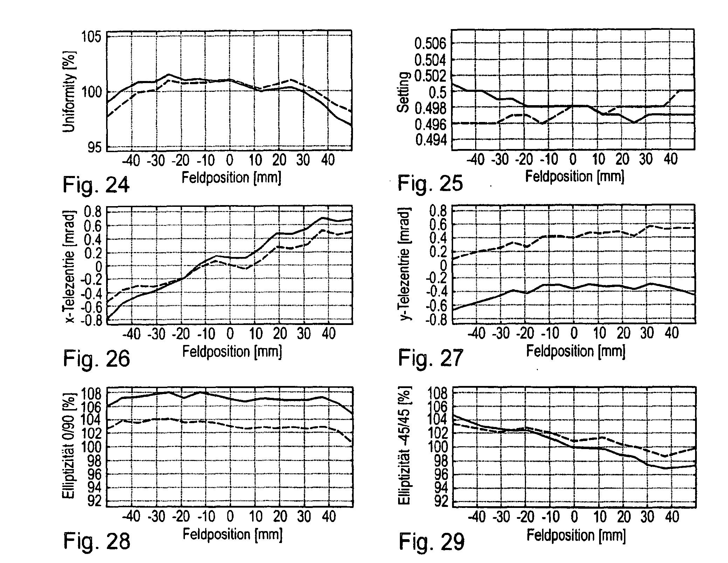

Die Fig. 24 bis 29 zeigen die korrigierende Wirkung der Korrekturblende 26 im Vergleich zur unkorrigierten Blende 24 in einer Darstellung, die derjenigen nach den Fig. 12 bis 17 entspricht. Die x-Telezentrie variiert beim Einsatz der Korrekturblende 26 nur noch zwischen -0,5 und 0,5 mrad. Die y-Telezentrie variiert lediglich noch zwischen 0,1 und 0,55 mrad. Die Elliptizität $E_{0°/90°}$ variiert nur noch zwischen 100 und 104 %. Die Elliptizität $K_{-45°/45°}$ variiert nur noch zwischen 99 und 103 %.

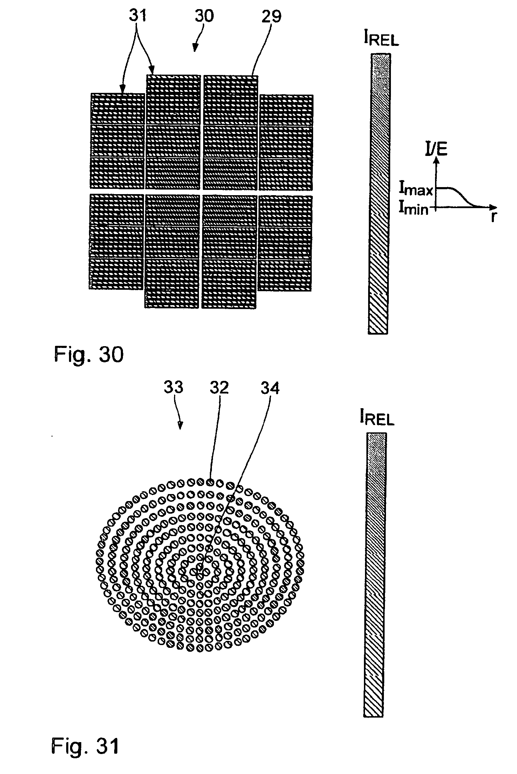

Anhand der Fig. 30 bis 40 wird nachfolgend eine weitere Ausführung der Projektionsbelichtungsanlage bei Verwendung eines Austausch-Beleuchtungsmoduls 22" und einer weiteren Korrekturblende dargestellt. Komponenten, die denjenigen entsprechen, die vorstehend schon unter Bezugnahme auf die Ausführungen nach den Fig. 1 bis 29 beschrieben wurden, tragen die gleichen Bezugsziffern und werden nicht nochmals im Einzelnen erläutert.

Beim Austauschbeleuchtungsmodul 22" wird eine Strahlungsquelle eingesetzt, die als Flächenstrahler mit winkelabhängiger Abstrahlung ausgestaltet ist.

Einzelfacetten 29 eines Feldfacettenspiegels 30, der bei der Ausführung nach den Fig. 30 bis 40 anstelle des Feldfacettenspiegels 11 eingesetzt wird, sind nicht gebogen, sondern langgestreckt rechteckig. Die Einzelfacetten 29 sind zu rechteckigen Facettengruppen 31 zusammengefasst.

Bei der Ausführung nach den Fig. 30 bis 40 haben die Einzelfacetten 29 und die Facettengruppen 31 des Feldfacettenspiegels 30 nicht die Form des zu beleuchtenden Objektfeldes in der Objektebene 5. Bei dieser Ausführung wird anstelle des objektfeldnahen Spiegels 16c ein das Beleuchtungsfeld in der Objektebene 5 formender Spiegel 16c' eingesetzt. Um eine Verzeichnung, die durch diesen feldformenden Spiegel 16c' erzeugt wird, auszugleichen, sind Pupillen-Einzelfacetten 32 eines Pupillenfacettenspiegels 33, der anstelle des Pupillenfacettenspiegels 15 eingesetzt wird, nicht rotationssymmetrisch um einen Ursprung 34, wie beim Pupillenfacettenspiegel 15, sondern ausgleichend verzerrt angeordnet. Beim Pupillenfacettenspiegel 33 erfolgt dies durch eine Anordnung der Pupillen-Einzelfacetten 32 in nicht vollkommen konzentrischen Facettenringen, wobei der Abstand zwischen den Facettenringen in der Fig. 31 oberhalb des Ursprungs 34 größer ist als unterhalb des Ursprungs.

Neben der Verteilung der Pupillen-Einzelfacetten 32 zeigt die Fig. 31 auch noch die Ausleuchtung der Pupillen-Einzelfacetten 32 mit Strahlungs-Teilbündeln der EUV-Strahlung 8 unterschiedlicher Energie bzw. Intensität aufgrund der Ausleuchtung der zugeordneten Feld-Einzelfacetten 29 des Feldfacettenspiegels mit unterschiedlicher Energie bzw. Intensität, wie im Diagramm auf der Seite Fig. 30 rechts angedeutet. Ähnlich wie bei der Ausleuchtung des Feldfacettenspiegels 11 nach der Fig. 2 ist auch bei der Ausleuchtung des Feldfacettenspiegels 30 nach Fig. 30 ein zentraler Bereich mit höherer Energie bzw. Intensität ausgeleuchtet als ein Randbereich. Die Intensität bzw. Energie (I bzw. E) fällt von einer zentralen Intensität $I_{max}$ kontinuierlich hin zu einer randseitigen Intensität bzw. Energie $I_{min}$ ab. Für das Verhältnis $I_{max}/I_{min}$ gilt, was vorstehend im Zusammenhang mit dem entsprechenden Verhältnis bei der Ausleuchtung nach Fig. 2 erläutert wurde.

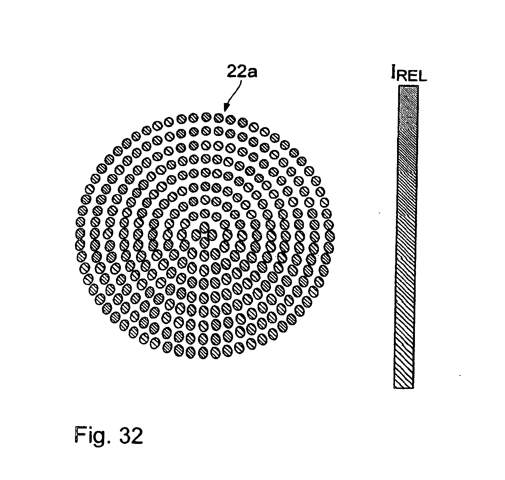

Fig. 32 zeigt wiederum schematisch eine scanintegrierte Ausleuchtung eines mittigen Objektfeldpunktes (x = 0).

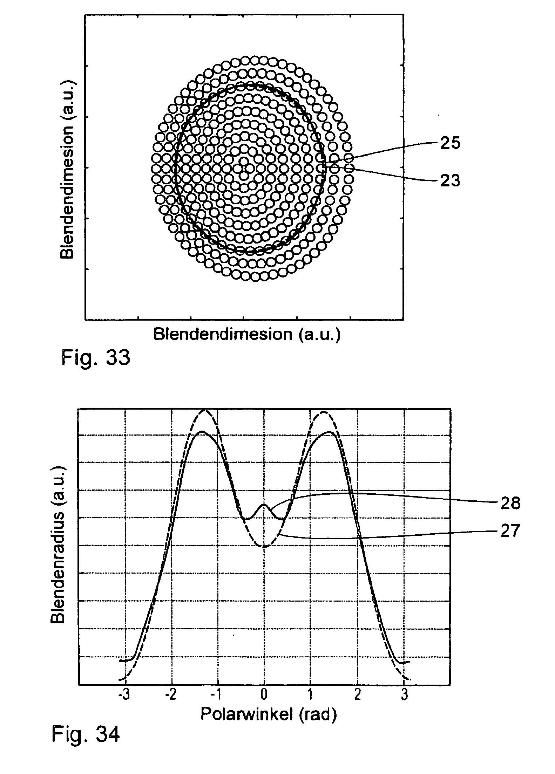

Fig. 33 zeigt entsprechend der Fig. 10 innere Blendenränder 23, 25 einerseits einer unkorrigierten Blende 24 und andererseits einer Korrekturblende 26. Fig. 34 zeigt entsprechend Fig. 11 in einer Polarkoordinatendarstellung die Radiusverläufe 27, 28 der unkorrigierten Blende 24 einerseits und der Korrekturblende 26 andererseits. Charakteristisch für die Korrekturblende 26 ist ein weiteres lokales Maximum bei der Polarkoordinate 0, in der Fig. 33 also in der 3-Uhr-Position. Hierdurch werden dort gelegene Pupillen-Einzelfacetten 29 des von außen gesehen dritten Facettenrings beim Einsatz der Korrekturblende 26 noch vollständig durchgelassen, während sie beim Einsatz der unkorrigierten Blende 24 fast zur Hälfte abgeschnitten werden.

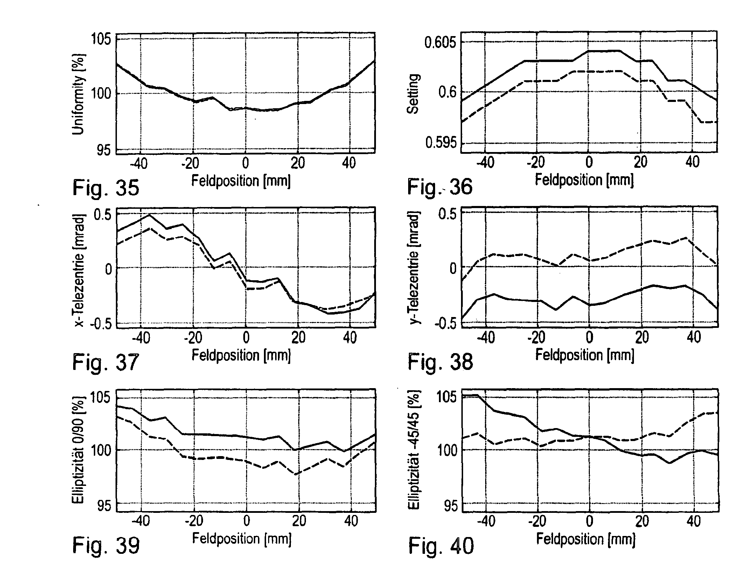

Fig. 35 bis 40 zeigen entsprechend den Fig. 12 bis 17 den Feldverlauf der optischen Größen Uniformity, Setting, Telezentrie und Elliptizität.

Das eingestellte Zielsetting σ = 0,6 wird beim Einsatz der Korrekturblende 26, über das gesamte Feld gesehen, stets mit nur geringen Abweichungen erreicht. Vor allem die y-Telezentrie ist beim Einsatz der Korrekturblende 26 im Vergleich zum Einsatz der unkorrigierten Blende 24 stark verbessert und weist nur noch geringe Abweichungen von 0 auf. Auch die Schwankungsbreiten bei den Elliptizitäten $E_{0°/90°}$ und $R_{45°/45°}$ sind beim Einsatz der Korrekturblende 26 im Vergleich zum Einsatz der unkorrigierten Blende 24 verringert.

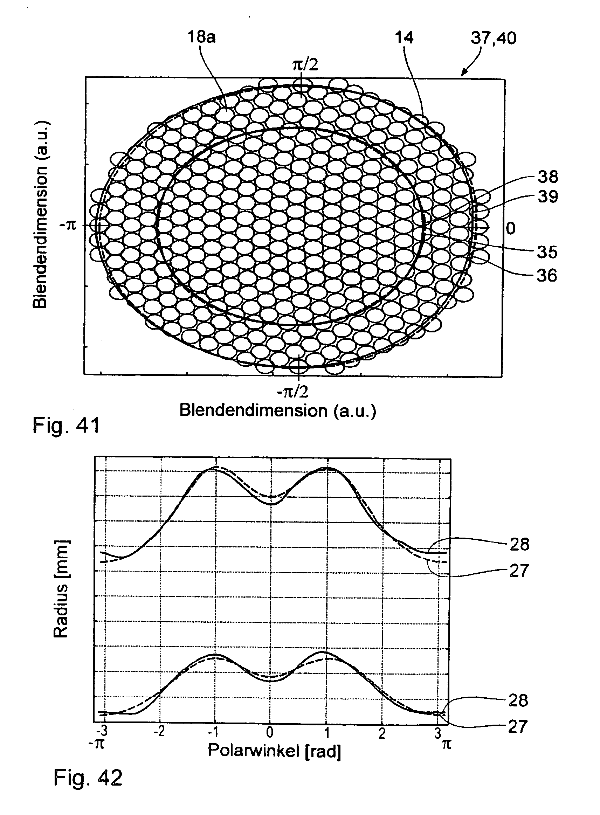

Fig. 41 bis 46 zeigen eine weitere Ausführung einer Korrekturblende sowie deren Wirkung. Komponenten, die denjenigen entsprechen, die vorstehend schon unter Bezugnahme auf die Fig. 1 bis 40 dargestellt wurden, tragen die gleichen Bezugsziffern und werden nicht nochmals im Einzelnen erläutert.

Bei der Ausführung nach Fig. 41 wird eines der vorstehend schon beschriebenen Beleuchtungsmodule eingesetzt, z. B. das Beleuchtungsmodul 21.

Fig. 41 zeigt gestrichelt einen inneren Blendenrand 35 und einen äußeren Blendenrand 36 einer unkorrigierten annularen Blende 37, die anstelle der Korrekturblende 17 bzw. 26 zur Erzeugung eines annularen Beleuchtungssettings angeordnet werden kann. Die korrigierte Blende 37 lässt EUV-Strahlung 8 ausschließlich im Ring zwischen dem inneren Blendenrand 35 und dem äußeren Blendenrand 36 durch.

Durchgezogen dargestellt ist in der Fig. 41 ein innerer Blendenrand 38 und ein äußerer Blendenrand 39 einer Korrekturblende 40, die anstelle der Korrekturblenden 17, 26 in der Projektionsbelichtungsanlage 1 nach Fig. 1 eingesetzt werden kann. Die Blendenränder 38, 39 begrenzen eine ringförmige Durchgangsöffnung 18a.

Die Radiusverläufe 27, 28 der Blendenränder 35, 38 einerseits und 36, 39 andererseits unterscheiden sich so gering, dass die diese kennzeichnenden Linien in der Fig. 41 bereichsweise übereinander verlaufen. Deutlicher werden die Unterschiede zwischen den Radiusverläufen 27 der unkorrigierten Blende 37 und 28 der Korrekturblende 40 in der Polardarstellung nach Fig. 42. Dargestellt sind dort die Radiusverläufe 27, 28 zwischen -π und π. Deutlich zu sehen ist, dass bei einem Polarwinkel 0, also in 3-Uhr-Position der Fig. 41, die unkorrigierte Blende 37 sowohl am inneren Blendenrand 35 als auch am äußeren Blendenrand 36 einen größeren Radius hat als die Korrekturblende 40 am inneren Blendenrand 38 und am äußeren Blendenrand 39. Dies führt dazu, dass die Korrekturblende im Bereich der 3-Uhr-Position weniger Licht der äußeren Pupillen-Einzelfacetten 14 und mehr Licht der inneren Pupillen-Einzelfacetten 14 durchlässt.

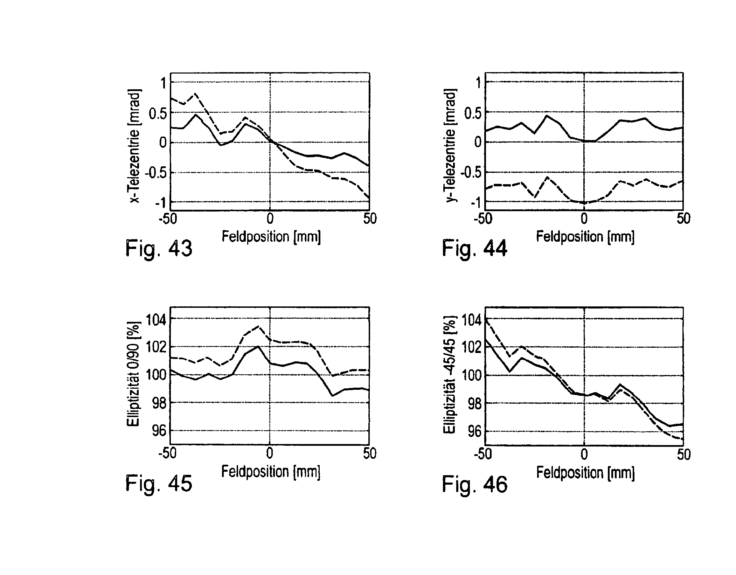

Die Fig. 43 bis 46 zeigen in einer Parameterdarstellung, die derjenigen der Fig. 14 bis 17 entspricht, die Wirkung der Korrekturblende 40 auf die optischen Parameter Telezentrie und Elliptizität.

Fig. 43 zeigt, dass die x-Telezentrie beim Einsatz der Korrekturblende 40 nur noch in einem geringen Intervall zwischen 0,5 und -0,5 mrad variiert.

Fig. 44 zeigt, dass die y-Telezentrie beim Einsatz der Korrekturblende 40 nur noch zwischen 0 und 0,5 mrad variiert.

Fig. 45 zeigt, dass die Elliptizität $E_{0°/90°}$ beim Einsatz der Korrekturblende 40 nur zwischen 98,5 % und 103 % variiert.

Fig. 46 zeigt, dass auch die Variation der Elliptizität $E_{-45°/45°}$ beim Einsatz der Korrekturblende 40 weniger stark variiert, nämlich zwischen 96,5 % und 102,5 %, als beim Einsatz der unkorrigierten Blende 37.

Alternativ zur optischen Auslegung der Projektionsbelichtungsanlage 1 nach Fig. 1 kann die Projektionsoptik 6 so ausgestaltet sein, dass deren Eintrittspupille im Bereich der optischen Komponenten der Beleuchtungsoptik 4 liegt. Hierdurch kann auf die abbildenden Spiegel 16a, 16b der Übertragungsoptik 16 zur Ausbildung einer konjugierten Pupillenebene im Bereich des Pupillenfacettenspiegels 15 verzichtet werden. Der Pupillenfacettenspiegel 15 wird in diesem Fall direkt in der Eintritts-Pupillenebene der Projektionsoptik 6 angeordnet und das vom Pupillenfacettenspiegel 15 ausgehende Licht wird über einen ähnlich zum Spiegel 16c angeordneten Umlenkspiegel direkt zur Objektebene 5 geleitet.

Die Korrekturblenden 17, 26, 40 können auch in einer zur Pupillenebene, in der der Pupillenfacettenspiegel 15, 33 angeordnet ist, konjugierten Pupillenebene angeordnet sein. Die Anordnung kann dann so sein, dass die EUV-Strahlung 8 die Korrekturblende 17, 26, 40 nur ein einziges Mal, also nicht im Hin- und Rücklauf, durchtritt.

Die Korrekturblenden 17, 26, 40 decken den Pupillenfacettenspiegel derart ab, dass zumindest einige Pupillen-Einzelfacetten 14, 32 des Pupillenfacettenspiegels 15, 33 von ein und demselben Blendenrand 19, 25, 38, 39 teilweise abgeschattet werden.

Die Korrekturblende 17 hat einen statischen Blendenrand 19. Alternativ kann der Blendenrand in seinem Radius zumindest im Korrekturabschnitt 20 einstellbar sein. Dies kann beispielsweise durch eine bewegliche Zunge 20a (vgl. Fig. 5) erfolgen, die in Richtung eines Doppelpfeils 20b in die Durchgangsöffnung 18 eingefahren oder aus dieser herausgefahren werden kann.

Auch die Blendenränder 28 bzw. 38, 39 der Korrekturblenden 26, 40 können in ihren Radiusverläufen einstellbar sein. Dies kann durch Aufbau der Korrekturblenden 26, 40 in Segmentbauweise zum Beispiel nach Art einer Irisblende oder durch Aufbau der Korrekturblenden 26, 40 mit voneinander unabhängig verlagerbaren Randabschnitten realisiert sein.

Bei der einstellbaren annularen Korrekturblende 40 kann nur einer der beiden Blendenränder einstellbar sein. Alternativ ist es auch möglich, beide Blendenränder, also den inneren Blendenrand und den äußeren Blendenrand, einstellbar zu gestalten.

Korrekturblenden nach Art der Korrekturblenden 17, 26, 40, die vorstehend unter Bezugnahme auf die Fig. 1 bis 46 beschrieben wurden, sind nicht auf konventionelle oder annulare Settings beschränkt. In gleicher Weise mit speziell geformten Begrenzungsrändern ausgestattete Korrekturblenden können auch zur Einstellung eines Dipol-Settings, Quadrupol-Settings, eines Multipol-Settings oder auch eines anderen, exotischen Settings eingesetzt werden. Beispiele derartiger Settings finden sich in der US 6,452,661 B1. Dipol- bzw. Quadrupol-Korrekturblenden haben zwei bzw. vier Durchgangsöffnungen, die von einem äußeren Blendenrand begrenzt sind. Die Form mindestens eines der Blendenränder ist bei den erfindungsgemäßen Korrekturblenden im Unterschied beispielsweise zu denen nach der US 6,452,661 B1 zur teilweisen Abschattung von Einzelfacetten des Pupillenfacettenspiegels zur Korrektur der Telezentrie und der Elliptizität der Beleuchtung vorgegeben.

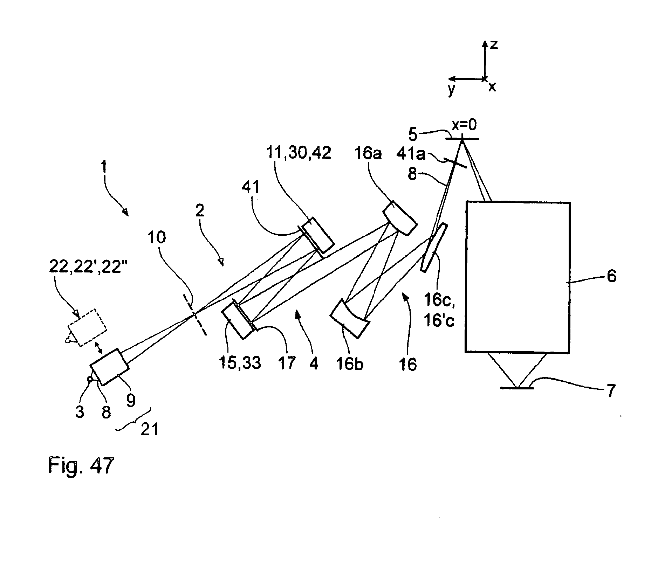

Fig. 47 zeigt ein weiteres Ausführungsbeispiel einer Projektionsbelichtungsanlage 1. Diese wird nachfolgend nur dort beschrieben, wo sie sich von derjenigen, die in der Fig. 1 dargestellt ist, unterscheidet. Benachbart zum Feldfacettenspiegel 11, 30 weist die Projektionsbelichtungsanlage 1 nach Fig. 47 ein Uniformity-Korrekturelement 41 auf. Dieses kann beispielsweise so aufgebaut sein, wie in der EP 1 291 721 A1 beschrieben, kann also eine Mehrzahl von verdrehbaren Einzel-Schneiden aufweise. Alternativ kann das Uniformity-Korrekturelement 41 auch aufgebaut sein, wie in der US 6 013 401 A1 beschrieben. Das Uniformity-Korrekturelement 41 ist benachbart zum Feldfacettenspiegel 11, 30, also im Bereich einer Feldebene der Projektionsoptik 6 angeordnet. Eine Alternativposition 41a des Uniformity-Korrekturelements ist in der Figur 47 benachbart zur Objektebene 5 angegeben.

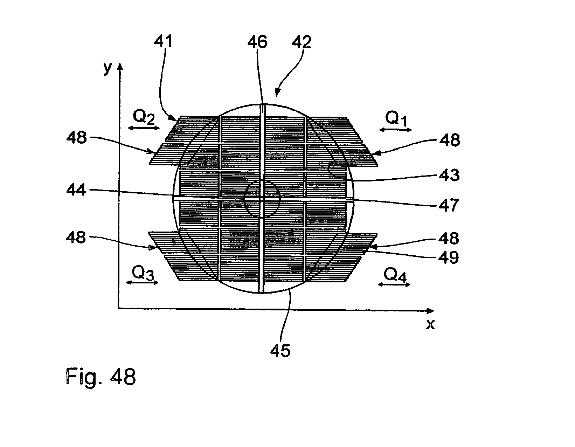

Eine weitere Variante eines Uniformity-Korrekturelements 41 wird nachfolgend anhand der Fig. 48 im Zusammenhang mit einer weiteren Ausführung eines Feldfacettenspiegels 42 beschrieben, der anstelle der Feldfacettenspiegel 11, 30 bei der Projektionsbelichtungsanlage 1 zum Einsatz kommen kann. Der Feldfacettenspiegel 42 ist unterteilt in insgesamt 312 Feld-Einzelfacetten 43. Die Feld-Einzelfacetten 43 sind, wie die Feld-Einzelfacetten der Feldfacettenspiegel 11, 30, an einer nicht dargestellten Trägerstruktur des Feldfacettenspiegels 42 angebracht. Die Feld-Einzelfacetten 43 sind rechteckig, wobei die kurze Seite der Feld-Einzelfacetten 43 entlang der Scanrichtung y verläuft und die lange Seite senkrecht hierzu, also entlang der Richtung x.

Fig. 48 zeigt beispielhaft und schematisch eine annulare Ausleuchtung des Feldfacettenspiegels 42 zwischen einem inneren Beleuchtungsradius 44 und einem äußeren Beleuchtungsradius 45.

Die Feld-Einzelfacetten 43 sind unterteilt in vier Spalten und 72 Reihen. Die Feld-Einzelfacetten 43 sind in untereinander angeordneten Blöcken zu je 13 Feld-Einzelfacetten 43 angeordnet. Je sechs dieser untereinander angeordneten Blöcke bilden eine Spalte des Feldfacettenspiegels 42. Zwischen den beiden inneren Spalten ist ein erster Schatten 46 von Speichen der Schalen des Kollektors 9 des Beleuchtungssystems 2 dargestellt. Zusammen mit einem zweiten, senkrecht hierzu angeordneten Schatten 47 ergibt sich eine zentrierte kreuzförmige Schattenstruktur auf dem Feldfacettenspiegel 42. Die Anordnung der Feld-Einzelfacetten 43 kann beim Feldfacettenspiegel 42 so sein, dass im Bereich der beiden Schatten 46, 47 keine Feldfacetten angeordnet sind.

Die beiden Schatten 46, 47 unterteilen den Feldfacettenspiegel in vier Quadranten Q1 bis Q4. Jedem dieser Quadranten ist eine Blendengruppe 48 zugeordnet. Die vier Blendengruppen 48 bilden gemeinsam das Uniformity-Korrekturelement 41 der Ausführung nach Fig. 48. Jede Blendengruppe 48 hat zwei Untergruppen aus Einzel-Fingerblenden 49, die jeweils zwei äußeren Blöcken von Feld-Einzelfacetten 43 in den Quadranten Q1 bis Q4 zugeordnet sind. Bei den zugeordneten Blöcken handelt es sich um diejenigen, deren Feld-Einzelfacetten 43 vom äußeren Beleuchtungsradius 45 in einen beleuchteten und einen unbeleuchteten Anteil unterteilt werden.

Die Einzel-Fingerblenden 49 der vier Blendengruppen 48 können unabhängig voneinander in x-Richtung verschoben werden, sodass sie die beleuchteten Anteile der ihnen zugeordneten Feld-Einzelfacetten 43 definiert bereichsweise abschatten können. Durch diese bereichsweise Abschattung wird beeinflusst, mit welcher Intensität die diesen Feld-Einzelfacetten 43 zugeordneten Pupillen-Einzelfacetten ausgeleuchtet werden. Mit dieser Ausleuchtung im direkten Zusammenhang steht die Uniformity, also die Variation der Intensität bzw. Energie, die ein Waferabschnitt während eines Scans durch das Bildfeld sieht.

Beim Betrieb der Projektionsbelichtungsanlage 1 kann zwischen verschiedenen korrigierten Settings durch Wechsel zwischen den Korrekturblenden 17, 26, 40 gewechselt werden. Der Wechsel des Beleuchtungssettings kann dabei in verschiedener Weise erfolgen, wie dies an sich aus dem Stand der Technik bekannt ist. Eine Möglichkeit zum Settingwechsel ist es, in der Pupillenebene das Beleuchtungslicht gezielt abzublenden. Hierzu werden insbesondere die Korrekturblenden 17, 26, 40 selbst eingesetzt. Ein Beleuchtungssettingwechsel kann auch erfolgen, indem gezielt Feld-Einzelfacetten abgeblendet werden, sodass entsprechend bestimmte Pupillen-Einzelfacetten nicht mehr ausgeleuchtet werden, was ebenfalls die Beleuchtungswinkelverteilung im Bildfeld ändert. Zum Abblenden der Feldfacetten kann auch das Uniformity-Korrekturelement 41 eingesetzt werden. Beispielsweise kann mit den Einzel-Fingerblenden 49 eine entsprechende gezielte Abschattung der Feld-Einzelfacetten 43 und damit eine Abschattung der diesen zugeordneten Pupillen-Einzelfacetten mit entsprechenden Auswirkungen auf das Beleuchtungssetting herbeigeführt werden. Schließlich ist eine Variante des Beleuchtungssettingwechsels möglich, die in der US 6 658 084 B2 beschrieben ist. Hierbei erfolgt zum Settingwechsel eine variable Zuordnung der Feld-Einzelfacetten zu den Pupillen-Einzelfacetten.

Dem Wechsel des Beleuchtungssettings und/oder dem Wechsel zwischen verschiedenen Beleuchtungsmodulen nachgelagert kann eine Anpassung bzw. ein Auswechseln des Uniformity-Korrekturelements 41 sein. Hierdurch wird dem Umstand Rechnung getragen, dass sich der Beleuchtungssettingwechsel bzw. der Wechsel des Beleuchtungsmoduls auf die Uniformity auswirken kann, was mit Hilfe des Uniformity-Korrekturelements 41 wieder korrigiert werden kann. Die Schritte "Wechsel des Beleuchtungssettings" und/oder "Wechsel des Beleuchtungsmoduls" einerseits sowie "Anpassung und/oder Auswechslung des Uniformity-Korrekturelements" können iterativ durchgeführt werden, um ein bestimmtes Ziel-Beleuchtungssetting mit einer gewünschten Uniformity zu erreichen.

Zudem ist ein Betriebsverfahren in der Projektionsbelichtungsanlage 1 möglich, bei dem zwischen verschiedenen Beleuchtungsmodulen 21, 22, 22', 22" gewechselt wird. Hierzu wird die Projektionsbelichtungsanlage 1 zunächst mit einem ersten der Beleuchtungsmodule 21, 22, 22', 22" beleuchtet. Dabei ist die jeweilige Korrekturblende 17, 26, 40 eingesetzt, die zur Korrektur der Telezentrie und der Elliptizität der Beleuchtung mit dem jeweiligen Beleuchtungsmodul 21, 22, 22', 22" vorgesehen ist. Anschließend wird das Beleuchtungsmodul gegen ein zweites Beleuchtungsmodul ausgetauscht. Zum Beispiel kann das Beleuchtungsmodul 21 gegen das Austausch-Beleuchtungsmodul 22 ausgewechselt werden. In diesem Fall wird die Korrekturblende gemäß Fig. 10 gegen die Korrekturblende 26 gemäß Fig. 22 ausgetauscht. Anschließend kann die Projektionsbelichtungsanlage 1 mit dem Austausch-Beleuchtungsmodul 22 weiter betrieben werden.

Die Korrekturblenden 17, 26, 40 können benachbart zum Pupillenfacettenspiegel 15, 33 oder aber im Bereich einer zu den Pupillenfacettenspiegeln 15, 33 konjugierten Pupillenebene der Beleuchtungsoptik 4 angeordnet sein. In jedem Fall werden durch ein und denselben Blendenrand 19, 25, 38, 39 der Korrekturblende 17, 26, 40 zumindest einige den Einzelfacetten 14, 32 des Pupillenfacettenspiegels 15, 33 zugeordnete Quellbilder in der Eintrittspupille der Projektionsoptik 6 teilweise abgeschattet.

Durch den Einsatz der Korrekturblenden 17, 26, 40 ist es auch möglich, einen Verzeichnungsfehler zu kompensieren, der durch die Übertragungsoptik 16, insbesondere durch den Spiegel 16c für streifenden Einfall (grazing incidence Spiegel) hervorgerufen wird. Auf einen derartigen Verzeichnungsfehler ist beispielsweise in der EP 1 067 437 B1 in Zusammenhang mit der dortigen Beschreibung der Figuren 18 bis 22 hingewiesen. Es ist beispielsweise möglich, durch Einsetzen einer elliptischen Korrekturblende am Ort der Korrekturblende 17 in Fig. 1 und der hierdurch erfolgenden Vorgabe eines in der Pupillenebene elliptischen Bündels der EUV-Strahlung 8 eine auf Grund der Verzeichnungswirkung der nachfolgenden Übertragungsoptik 16 dennoch rotationssymmetrische Beleuchtungswinkelverteilung für die Feldpunkte in der Objektebene 5 zu erzielen. Diese Verzeichnungskompensation kann auch durch eine andere, nicht rotationssymmetrische Form des Blendenrandes der Korrekturblende am Ort der Korrekturblende 17 herbeigeführt werden. Die genaue Form des Blendenrandes wird abhängig von der nachfolgenden Verzeichnungswirkung der Übertragungsoptik 16 vorgegeben.

Die folgenden Sätze beschreiben Ausführungsformen . Hierbei handelt es sich nicht um Ansprüche im Einklang mit der Entscheidung J15/88 der juristischen Beschwerdekammer.

1. Projektionsbelichtungsanlage (1) für die Mikrolithographie

- mit einer Beleuchtungsoptik (4) zur Beleuchtung eines Objektfeldes in einer Objektebene (5),

-- wobei die Beleuchtungsoptik (4) in einem Strahlengang vor der Objektebene (5) eine abbildende optische Baugruppe (16) zur Bündelführung von Beleuchtungs- und Abbildungslicht (8) in das Objektfeld aufweist,

- mit einer Projektionsoptik (6) zur Abbildung des Objektfeldes in ein Bildfeld in einer Bildebene (7),
- mit einer Korrekturblende (17; 26; 40), deren Blendenrand (19; 25; 38; 39) zur teilweisen Abschattung des Beleuchtungs- und Abbildungslichts (8) so ausgeführt ist, dass der Einfluss eines Verzeichnungsfehlers, der durch Reflexion des Beleuchtungs- und Abbildungslichts (8) an Komponenten der abbildenden optischen Baugruppe (16) entsteht, auf eine Beleuchtungswinkelverteilung der Beleuchtung des Objektfeldes zumindest teilweise kompensiert ist.

2. Projektionsbelichtungsanlage nach Satz 1, dadurch gekennzeichnet, dass die Korrekturblende (17; 26; 40) in oder benachbart zu einer Pupillenebene der Projektionsoptik (6) angeordnet ist.

3. Projektionsbelichtungsanlage nach Satz 1, dadurch gekennzeichnet, dass die Korrekturblende (17; 26; 40) in oder benachbart zu einer Ebene angeordnet ist, die zu einer Pupillenebene der Projektionsoptik (6) konjugiert ist.

4. Projektionsbelichtungsanlage nach einem der Sätze 1 bis 3, dadurch gekennzeichnet, dass die Beleuchtungsoptik (4) einen Pupillenfacettenspiegel (15; 33) aufweist, der eine Mehrzahl von mit Beleuchtungslicht (8) beaufschlagbaren Einzelfacetten (14; 32) aufweist und in einer Ebene der Beleuchtungsoptik (4) angeordnet ist, die mit einer Pupillenebene der Projektionsoptik (6) zusammenfällt oder zu dieser optisch konjugiert ist.

5. Projektionsbelichtungsanlage nach Satz 4, dadurch gekennzeichnet, dass die Korrekturblende (17; 26; 40) so angeordnet ist, dass zumindest einige Quellbilder in der Eintrittspupille der Projektionsoptik (6), die den Einzelfacetten (14; 32) des Pupillenfacettenspiegels (15; 33) zugeordnet sind, von ein und demselben Blendenrand (19; 25; 38; 39) teilweise abgeschattet werden.

6. Projektionsbelichtungsanlage nach einem der Sätze 1 bis 5, dadurch gekennzeichnet, dass die Beleuchtungsoptik (4) einen Feldfacettenspiegel (11) mit Feldfacetten (13) aufweist, wobei die abbildende optische Baugruppe (16) so ausgeführt ist, dass die Feldfacetten (13) in das Objektfeld abgebildet werden.

7. Projektionsbelichtungsanlage nach Satz 6, dadurch gekennzeichnet, dass die Feldfacetten (13) bogenförmig ausgeführt sind.

8. Projektionsbelichtungsanlage nach einem der Sätze 1 bis 7, dadurch gekennzeichnet, dass die abbildende optische Baugruppe (16) einen Spiegel für streifenden Einfall (16c) aufweist.

9. Projektionsbelichtungsanlage nach einem der Sätze 4 bis 8, dadurch gekennzeichnet, dass die Korrekturblende (17; 26; 40) dem Pupillenfacettenspiegel (15; 33) benachbart angeordnet ist.

10. Projektionsbelichtungsanlage nach einem der Sätze 1 bis 9, dadurch gekennzeichnet, dass die Korrekturblende (17; 26; 40) an einer Umfangsposition des Blendenrandes (19) mindestens einen Korrekturabschnitt (20) aufweist, an dem die Umfangskontur, insbesondere der Radius des Blendenrandes (19) von einer sonstigen, unkorrigierten Umfangskontur um einen Korrekturbetrag abweicht.

11. Projektionsbelichtungsanlage (1) für die Mikrolithographie

- mit einer Beleuchtungsoptik (4) zur Beleuchtung eines Objektfeldes in einer Objektebene (5),
- mit einer Projektionsoptik (6) zur Abbildung des Objektfeldes in ein Bildfeld in einer Bildebene (7),
- mit einem Pupillenfacettenspiegel (15; 33), der eine Mehrzahl von mit Beleuchtungslicht (8) beaufschlagbaren Einzelfacetten (14; 32) aufweist und in einer Ebene der Beleuchtungsoptik (4) angeordnet ist, die mit einer Pupillenebene der Projektionsoptik (6) zusammenfällt oder zu dieser optisch konjugiert ist, gekennzeichnet durch
- eine Korrekturblende (17; 26; 40), die in oder benachbart zu einer Pupillenebene der Projektionsoptik (6) oder in einer hierzu konjugierten Ebene angeordnet ist und die Ausleuchtung der Eintrittspupille der Projektionsoptik (6) derart abdeckt, dass zumindest einige Quellbilder in der Eintrittspupille der Projektionsoptik (6), die den Einzelfacetten (14; 32) des Pupillenfacettenspiegels (15; 33) zugeordnet sind, von ein und demselben Blendenrand (19; 25; 38; 39) teilweise abgeschattet werden.

12. Projektionsbelichtungsanlage nach Satz 11, dadurch gekennzeichnet, dass die Korrekturblende (17; 26; 40) dem Pupillenfacettenspiegel (15; 33) benachbart angeordnet ist.

13. Projektionsbelichtungsanlage nach Satz 11 oder 12, dadurch gekennzeichnet, dass die Korrekturblende (17; 26; 40) an einer Umfangsposition des Blendenrandes (19) mindestens einen Korrekturabschnitt (20) aufweist, an dem die Umfangskontur, insbesondere der Radius, des Blendenrands (19) von einer sonstigen, unkorrigierten Umfangskontur um einen Korrekturbetrag abweicht.

14. Projektionsbelichtungsanlage nach Satz 11 oder 12, dadurch gekennzeichnet, dass die Korrekturblende (26; 40) längs des gesamten Blendenrandes (25; 38, 39) einen kontinuierlichen Korrekturverlauf aufweist.

15. Projektionsbelichtungsanlage nach Satz 14, dadurch gekennzeichnet, dass die Korrekturblende (26; 40) längs des Blendenrandes (25; 38, 39) von einer unkorrigierten Umfangskontur, insbesondere einem unkorrigierten Radius, kontinuierlich um einen Korrekturbetrag abweicht.

16. Projektionsbelichtungsanlage nach einem der Sätze 11 bis 15, gekennzeichnet, durch eine Korrekturblende (17; 26; 40) mit einem Blendenrand (20a), der in seiner Umfangskontur, insbesondere in seinem Radius, zumindest in einem Korrekturabschnitt einstellbar ist.

17. Projektionsbelichtungsanlage nach einem der Sätze 11 bis 16, dadurch gekennzeichnet, dass die Korrekturblende (17; 26) aufweist:

- eine einzige zentrale Durchgangsöffnung (18), die von genau einem Blendenrand (19; 25) begrenzt ist.

18. Projektionsbelichtungsanlage nach einem der Sätze 11 bis 16, dadurch gekennzeichnet, dass die Korrekturblende (40) aufweist:

- eine ringförmige Durchgangsöffnung (18a), die von einem inneren Blendenrand (38) und einem äußeren Blendenrand (39) begrenzt ist.

19. Projektionsbelichtungsanlage nach einem der Sätze 11 bis 16, dadurch gekennzeichnet, dass die Korrekturblende aufweist:

- eine Mehrzahl von Durchgangsöffnungen, die von einem äußeren Blendenrand begrenzt sind.

20. Projektionsbelichtungsanlage nach einem der Sätze 1 bis 19, gekennzeichnet durch eine EUV-Lichtquelle (3).

21. Beleuchtungsoptik (4) mit einem Pupillenfacettenspiegel (15; 33) und einer Korrekturblende (17; 26; 40), deren Blendenrand (19; 25; 38; 39) zur teilweisen Abschattung von Beleuchtungs- und Abbildungslicht (8) so ausgeführt ist, dass der Einfluss eines Verzeichnungsfehlers auf eine Beleuchtungswinkelverteilung der Beleuchtung des Objektfeldes, der durch Reflexion von Beleuchtungs- und Abbildungslicht (8) an Komponenten einer abbildenden optischen Baugruppe (16) zur Bündelfiihrung von Beleuchtungs- und Abbildungslicht (8) in ein Objektfeld (8) entsteht, zumindest teilweise kompensiert ist, für ein Beleuchtungssystem (2) einer Projektionsbelichtungsanlage (1).

22. Verfahren zum Betrieb einer Projektionsbelichtungsanlage (1) nach einem der Sätze 1 bis 20 mit folgenden Schritten:

- Betreiben der Projektionsbelichtungsanlage (1) mit einer ersten Beleuchtungsgeometrie (21),
- Auswechseln der ersten Beleuchtungsgeometrie gegen eine zweite Beleuchtungsgeometrie,
- Auswechseln der Korrekturblende (17; 26; 40) gegen eine Austausch-Blende (17; 26; 40), deren Blendenrand (19; 25; 38, 39) so ausgestaltet ist, dass zumindest einige Quellbilder in der Eintrittspupille der Projektionsoptik (6), die den Einzelfacetten (14, 32) des Pupillenfacettenspiegels (15; 33) zugeordnet sind, von ein und demselben Blendenrand (19; 25; 38, 39) teilweise abgeschattet werden, wobei die Form des Blendenrandes (19; 25; 38, 39) zur teilweisen Abschattung zur Korrektur der Telezentrie und Elliptizität der Beleuchtung, angepasst an die zweite Beleuchtunggeometrie (22, 22', 22"), vorgegeben ist,
- Betreiben der Projektionsbelichtungsanlage (1) mit der zweiten Beleuchtungsgeometrie (22, 22', 22").

23. Verfahren nach Satz 22, bei dem beim Auswechseln der Beleuchtungsgeometrie zusätzlich zum Wechseln der Korrekturblende (17; 26; 40) eine Anpassung oder eine Auswechslung eines weiteren Korrekturelements (41) zur Anpassung der Gleichmäßigkeit der Ausleuchtung über das Bildfeld erfolgt.

24. Verfahren zur Herstellung eines mikrostrukturierten Bauteils mit folgenden Verfahrensschritten:

- Bereitstellen eines Wafers, auf den zumindest teilweise eine Schicht aus einem lichtempfindlichen Material aufgebracht ist,
- Bereitstellen eines Retikels, das abzubildende Strukturen aufweist,
- Bereitstellen einer Projektionsbelichtungsanlage (1) nach einem der Sätze 1 bis 20,
- Projizieren wenigstens eines Teils des Retikels auf einen Bereich der Schicht mit Hilfe der Projektionsoptik (6) der Projektionsbelichtungsanlage (1).

25. Verfahren nach Satz 24, dadurch gekennzeichnet, dass der Blendenrand (19; 25; 38, 39) der Korrekturblende (17; 26; 40) zur teilweisen Abschattung des Beleuchtungs- und Abbildungslichts (8) vor dem Projizieren so justiert wird, dass ein Verzeichnungsfehler, der durch Reflexion des Beleuchtungs- und Abbildungslichts (8) an Komponenten der abbildenden optischen Baugruppe (16) entsteht, zumindest teilweise kompensiert ist.

**Patentansprüche**

1.  Projektionsbelichtungsanlage (1) für die Mikrolithographie

    - mit einer Beleuchtungsoptik (4) zur Beleuchtung eines Objektfeldes in einer Objektebene (5),
    - mit einer Projektionsoptik (6) zur Abbildung des Objektfeldes in ein Bildfeld in einer Bildebene (7),
    - mit einem Pupillenfacettenspiegel (15; 33), der eine Mehrzahl von mit Beleuchtungslicht (8) beaufschlagbaren Einzelfacetten (14; 32) aufweist und in einer Ebene der Beleuchtungsoptik (4) angeordnet ist, die mit einer Pupillenebene der Projektionsoptik (6) zusammenfällt oder zu dieser optisch konjugiert ist,

    und mit einer Korrekturblende (17; 26; 40), die in oder benachbart zu einer Pupillenebene der Projektionsoptik (6) oder in einer hierzu konjugierten Ebene angeordnet ist
    die Korrekturblende (17; 26; 40) wobei die Ausleuchtung der Eintrittspupille der Projektionsoptik (6) derart abdeckt, dass zumindest einige Quellbilder in der Eintrittspupille der Projektionsoptik (6), die den Einzelfacetten (14; 32) des Pupillenfacettenspiegels (15; 33) zugeordnet sind, von ein und demselben Blendenrand (19; 25; 38; 39) teilweise abgeschattet werden **dadurch gekennzeichnet, dass** die Korrekturblende (26; 40) längs des gesamten Blendenrandes (25; 38, 39) einen kontinuierlichen Korrekturverlauf aufweist und längs des Blendenrandes (25; 38, 39) von einer unkorrigierten Umfangskontur, insbesondere einem unkorrigierten Radius, kontinuierlich um einen Korrekturbetrag abweicht
    und wobei der Radiusverlauf der Korrekturblende in Polarkoordinaten stärker und hochfrequenter moduliert ist als der Radiusverlauf der unkorrigierten Blende.

2.  Projektionsbelichtungsanlage nach Anspruch 1, **dadurch gekennzeichnet, dass** die Korrekturblende (17; 26; 40) dem Pupillenfacettenspiegel (15; 33) benachbart angeordnet ist.

3.  Projektionsbelichtungsanlage nach einem der Ansprüche 1 bis 2, **gekennzeichnet, durch** eine Korrekturblende (17; 26; 40) mit einem Blendenrand (20a), der in seiner Umfangskontur, insbesondere in seinem Radius, zumindest in einem Korrekturabschnitt einstellbar ist.

4.  Projektionsbelichtungsanlage nach einem der Ansprüche 1 bis 3, **dadurch gekennzeichnet, dass** die Korrekturblende (17; 26) aufweist:

    - eine einzige zentrale Durchgangsöffnung (18), die von genau einem Blendenrand (19; 25) begrenzt ist.

5.  Projektionsbelichtungsanlage nach einem der Ansprüche 1 bis 4, **dadurch gekennzeichnet, dass** die Korrekturblende (40) aufweist:

    - eine ringförmige Durchgangsöffnung (18a), die von einem inneren Blendenrand (38) und einem äußeren Blendenrand (39) begrenzt ist.

6.  Projektionsbelichtungsanlage nach einem der Ansprüche 1 bis 5, **dadurch gekennzeichnet, dass** die Korrekturblende aufweist:

    - eine Mehrzahl von Durchgangsöffnungen, die von einem äußeren Blendenrand begrenzt sind.

7.  Projektionsbelichtungsanlage nach einem der Ansprüche 1 bis 6, **gekennzeichnet durch** eine EUV-Lichtquelle (3).

8.  Verfahren zum Betrieb einer Projektionsbelichtungsanlage (1) nach einem der Ansprüche 1-7 mit folgenden Schritten:

    - Betreiben der Projektionsbelichtungsanlage (1) mit einer ersten Beleuchtungsgeometrie (21),
    - Auswechseln der ersten Beleuchtungsgeometrie gegen eine zweite Beleuchtungsgeometrie,
    - Auswechseln der Korrekturblende (17; 26; 40) gegen eine Austausch-Blende (17; 26; 40), deren Blendenrand (19; 25; 38, 39) so ausgestaltet ist, dass zumindest einige Quellbilder in der Eintrittspupille der Projektionsoptik (6), die den Einzelfacetten (14, 32) des Pupillenfacettenspiegels (15; 33) zugeordnet sind, von ein und demselben Blendenrand (19; 25; 38, 39) teilweise abgeschattet werden, wobei die Form des Blendenrandes (19; 25; 38, 39) zur teilweisen Abschattung zur Korrektur der Telezentrie und Elliptizität der Beleuchtung, angepasst an die zweite Beleuchtunggeometrie (22, 22', 22"), vorgegeben ist,
- Betreiben der Projektionsbelichtungsanlage (1) mit der zweiten Beleuchtungsgeometrie (22, 22', 22").

9. Verfahren nach Anspruch 8, bei dem beim Auswechseln der Beleuchtungsgeometrie zusätzlich zum Wechseln der Korrekturblende (17; 26; 40) eine Anpassung oder eine Auswechslung eines weiteren Korrekturelements (41) zur Anpassung der Gleichmäßigkeit der Ausleuchtung über das Bildfeld erfolgt.

10. Verfahren zur Herstellung eines mikrostrukturierten Bauteils mit folgenden Verfahrensschritten:

- Bereitstellen eines Wafers, auf den zumindest teilweise eine Schicht aus einem lichtempfindlichen Material aufgebracht ist,
- Bereitstellen eines Retikels, das abzubildende Strukturen aufweist,
- Bereitstellen einer Projektionsbelichtungsanlage (1) nach einem der Ansprüche 1 bis 7,
- Projizieren wenigstens eines Teils des Retikels auf einen Bereich der Schicht mit Hilfe der Projektionsoptik (6) der Projektionsbelichtungsanlage (1).

11. Verfahren nach Anspruch 10, **dadurch gekennzeichnet, dass** der Blendenrand (19; 25; 38, 39) der Korrekturblende (17; 26; 40) zur teilweisen Abschattung des Beleuchtungs- und Abbildungslichts (8) vor dem Projizieren so justiert wird, dass ein Verzeichnungsfehler, der durch Reflexion des Beleuchtungs- und Abbildungslichts (8) an Komponenten der abbildenden optischen Baugruppe (16) entsteht, zumindest teilweise kompensiert ist.

**Claims**

1. Projection exposure apparatus (1) for microlithography

- comprising an illumination optical unit (4) for illuminating an object field in an object plane (5),
- comprising a projection optical unit (6) for imaging the object field into an image field in an image plane (7),
- comprising a pupil facet mirror (15; 33), which has a plurality of individual facets (14; 32) on which illumination light (8) can impinge, and is arranged in a plane of the illumination optical unit (4) which coincides with a pupil plane of the projection optical unit (6) or is optically conjugate with respect thereto, and comprising a correction diaphragm (17; 26; 40), which is arranged in or adjacent to a pupil plane of the projection optical unit (6) or in a conjugate plane with respect thereto

the correction diaphragm (17; 26; 40) screening the illumination of the entrance pupil of the projection optical unit (6) in such a way that at least some source images in the entrance pupil of the projection optical unit (6) which are assigned to the individual facets (14; 32) of the pupil facet mirror (15; 33) are partly shaded by one and the same diaphragm edge (19; 25; 38; 39)
**characterized in that** the correction diaphragm (26; 40) has a continuous correction profile along the entire diaphragm edge (25; 38, 39) and deviates from an uncorrected circumferential contour, in particular an uncorrected radius, continuously by a correction absolute value along the diaphragm edge (25; 38, 39)
and the radius profile of the correction diaphragm in polar coordinates being modulated to a greater extent and at a higher frequency than the radius profile of the uncorrected diaphragm.

2. Projection exposure apparatus according to Claim 1, **characterized in that** the correction diaphragm (17; 26; 40) is arranged adjacent to the pupil facet mirror (15; 33).

3. Projection exposure apparatus according to any of Claims 1 to 2, **characterized by** a correction diaphragm (17; 26; 40) having a diaphragm edge (20a) which is adjustable in its circumferential contour, in particular in its radius, at least in one correction section.

4. Projection exposure apparatus according to any of Claims 1 to 3, **characterized in that** the correction diaphragm (17; 26) has:

- a single central passage opening (18) delimited by precisely one diaphragm edge (19; 25).

5. Projection exposure apparatus according to any of Claims 1 to 4, **characterized in that** the correction diaphragm (40) has:

   - a ring-shaped passage opening (18a) delimited by an inner diaphragm edge (38) and an outer diaphragm edge (39).

6. Projection exposure apparatus according to any of Claims 1 to 5, **characterized in that** the correction diaphragm has:

   - a plurality of passage openings delimited by an outer diaphragm edge.

7. Projection exposure apparatus according to any of Claims 1 to 6, **characterized by** an EUV light source (3).

8. Method for operating a projection exposure apparatus (1) according to any of Claims 1-7, comprising the following steps:

   - operating the projection exposure apparatus (1) with a first illumination geometry (21),
   - exchanging the first illumination geometry for a second illumination geometry,
   - exchanging the correction diaphragm (17; 26; 40) for a replacement diaphragm (17; 26; 40), the diaphragm edge (19; 25; 38, 39) of which is configured in such a way that at least some source images in the entrance pupil of the projection optical unit (6), which are assigned to the individual facets (14, 32) of the pupil facet mirror (15; 33), are partly shaded by one and the same diaphragm edge (19; 25; 38, 39), the form of the diaphragm edge (19; 25; 38, 39) being predefined, for the partial shading, for the correction of the telecentricity and ellipticity of the illumination, in a manner adapted to the second illumination geometry (22, 22', 22"),
   - operating the projection exposure apparatus (1) with the second illumination geometry (22, 22', 22").

9. Method according to Claim 8, wherein exchanging the illumination geometry involves, in addition to changing the correction diaphragm (17; 26; 40), carrying out an adaptation or an exchange of a further correction element (41) for adapting the uniformity of the illumination over the image field.

10. Method for producing a microstructured component, comprising the following method steps:

    - providing a wafer, to which a layer composed of a light-sensitive material is applied at least in part,
    - providing a reticle having structures to be imaged,
    - providing a projection exposure apparatus (1) according to any of Claims 1 to 7,
    - projecting at least one part of the reticle onto a region of the layer with the aid of the projection optical unit (6) of the projection exposure apparatus (1).

11. Method according to Claim 10, **characterized in that** the diaphragm edge (19; 25; 38, 39) of the correction diaphragm (17; 26; 40) is adjusted for the partial shading of the illumination and imaging light (8) before projection such that a distortion aberration that arises as a result of reflection of the illumination and imaging light (8) at components of the imaging optical assembly (16) is at least partially compensated for.

**Revendications**

1. Système d'exposition par projection (1) pour la microlithographie

   - comprenant une optique d'éclairement (4) pour éclairer un champ objet dans un plan objet (5),
   - comprenant une optique de projection (6) pour former dans un champ image une image du champ objet dans un plan image (7),
   - comprenant un miroir à facettes de pupille (15 ; 33) qui comprend une pluralité de facettes individuelles (14 ; 32) sur lesquelles la lumière d'éclairement (8) peut être incidente et disposé dans un plan de l'optique d'éclairement (4) qui coïncide avec un plan pupille de l'optique de projection (6) ou qui est optiquement conjugué de celui-ci,

   et comprenant un diaphragme de correction (17 ; 26 ; 40) qui est disposé dans ou à proximité immédiate d'un plan pupille de l'optique de projection (6) ou dans un plan conjugué de celui-ci,
dans lequel
le diaphragme de correction (17 ; 26 ; 40) occulte l'éclairement de la pupille d'entrée de l'optique de projection (6) de telle manière qu'au moins certaines des images sources qui sont associées aux facettes individuelles (14 ; 32) du miroir à facettes de pupille (15 ; 33) dans la pupille d'entrée de l'optique de projection (6) soient partiellement occultées par un seul et même bord de diaphragme (19 ; 25 ; 38 ; 39), **caractérisé en ce que** le diaphragme de correction (26 ; 40) présente une courbe de correction continue le long de la totalité du bord de diaphragme (25 ; 38, 39) et s'écarte en continu d'une valeur de correction par rapport à un contour circonférentiel non corrigé, notamment à un rayon non corrigé, le long du bord de diaphragme (25 ; 38, 39)
et dans lequel la courbe radiale du diaphragme de correction en coordonnées polaires est modulée plus fortement et à plus haute fréquence que la courbe radiale du diaphragme non corrigé.

2. Système d'exposition par projection selon la revendication 1, **caractérisé en ce que** le diaphragme de correction (17 ; 26 ; 40) est disposé de manière adjacente au miroir à facettes de pupille (15 ; 33).

3. Système d'exposition par projection selon l'une quelconque des revendications 1 à 2, **caractérisé par** un diaphragme de correction (17 ; 26 ; 40) ayant un bord de diaphragme (20a) dont le contour circonférentiel, et notamment le rayon, est réglable dans au moins une section de correction.

4. Système d'exposition par projection selon l'une quelconque des revendications 1 à 3, **caractérisé en ce que** le diaphragme de correction (17 ; 26) comprend :

    - une ouverture de passage centrale unique (18) qui est délimitée par exactement un bord de diaphragme (19 ; 25).

5. Système d'exposition par projection selon l'une quelconque des revendications 1 à 4, **caractérisé en ce que** le diaphragme de correction (40) comprend :

    - une ouverture de passage annulaire (18a) qui est délimitée par un bord de diaphragme intérieur (38) et par un bord de diaphragme extérieur (39).

6. Système d'exposition par projection selon l'une quelconque des revendications 1 à 5, **caractérisé en ce que** le diaphragme de correction comprend :

    - une pluralité d'ouvertures de passage qui sont délimitées par un bord de diaphragme extérieur.

7. Système d'exposition par projection selon l'une quelconque des revendications 1 à 6, **caractérisé par** une source de lumière EUV (3).

8. Procédé de mise en fonctionnement d'un système d'exposition par projection (1) selon l'une quelconque des revendications 1 à 7, comprenant les étapes suivantes :

    - mettre en fonctionnement le système d'exposition par projection (1) avec une première géométrie d'éclairement (21),
    - remplacer la première géométrie d'éclairement par une seconde géométrie d'éclairement,
    - remplacer le diaphragme de correction (17 ; 26 ; 40) par un diaphragme de remplacement (17 ; 26 ; 40) dont le bord de diaphragme (19 ; 25 ; 38, 39) est conçu de telle manière qu'au moins certaines des images sources qui sont associées aux facettes individuelles (14, 32) du miroir à facettes de pupille (15 ; 33) dans la pupille d'entrée de l'optique de projection (6), soient partiellement occultées par un seul et même bord de diaphragme (19 ; 25 ; 38, 39), la forme du bord de diaphragme (19 ; 25 ; 38, 39) étant prédéterminée pour l'occultation partielle du caractère télécentrique et de l'ellipticité de l'éclairement, de manière adaptée à la seconde géométrie d'éclairement (22, 22', 22"),
    - faire fonctionner l'appareil d'exposition par projection (1) avec la seconde géométrie d'éclairement (22, 22', 22").

9. Procédé selon la revendication 8, dans lequel un ajustement ou un remplacement d'un élément de correction supplémentaire (41) pour ajuster l'uniformité d'éclairement dans le champ image est effectué lors du remplacement de la géométrie d'éclairement en plus de la modification du diaphragme de correction (17 ; 26 ; 40).

10. Procédé de fabrication d'un composant microstructuré comprenant les étapes de procédé suivantes :

   - fournir une plaquette sur laquelle est déposée au moins partiellement une couche constituée d'un matériau photosensible,
   - fournir un réticule qui présente des structures dont des images doivent être formées,
   - fournir un système d'exposition par projection (1) selon l'une des revendications 1 à 7,
   - projeter au moins une partie du réticule sur une région de la couche à l'aide de l'optique de projection (6) du système d'exposition par projection (1).

11. Procédé selon la revendication 10, **caractérisé en ce que** le bord de diaphragme (19 ; 25 ; 38, 39) du diaphragme de correction (17 ; 26 ; 40) est ajusté pour l'occultation partielle de la lumière d'éclairement et de formation d'image (8) avant la projection, de manière à compenser au moins partiellement une erreur de déformation provoquée par la réflexion de la lumière d'éclairement et de formation d'image (8) sur des composants du module optique de formation d'image (16).

EP 2 100 190 B1

Fig. 1

Fig. 2

Fig. 3

20b

$I_{REL}$

Fig. 4

19  18  17  20  20a

$I_{REL}$

Fig. 5

3

$I_{REL}$

Fig. 6

11

$I_{REL}$

$I/E$

$I_{max}$
$I_{min}$

r

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

15

Fig. 20

22a

Fig. 21

Fig. 22

Fig. 23

Fig. 24

Fig. 25

Fig. 26

Fig. 27

Fig. 28

Fig. 29

Fig. 30

Fig. 31

Fig. 32

Fig. 33

Fig. 34

Fig. 35

Fig. 36

Fig. 37

Fig. 38

Fig. 39

Fig. 40

Fig. 41

Fig. 42

Fig. 44

Fig. 46

Fig. 43

Fig. 45

Fig. 47

Fig. 48

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1349009 A2
- US 6859328 B2
- US 6658084 B2
- WO 2005015314 A2
- US 6452661 B1
- US 20060012767 A1
- EP 1067437 B1

- US 20030031017 A1
- EP 1225481 A
- US 6452661 B
- US 6195201 B
- EP 1291721 A1
- US 6013401 A1